# EUROPEAN PATENT APPLICATION

(11) **EP 4 815 703 A1**
(43) Date of publication of application: **30.09.2026**
(21) Application number: 26156210.2
(22) Date of filing: 04.02.2026
(51) Int. Cl.: H10P 72/00, G01N 21/95, H04N 23/20, H10P 74/20

(54) **DEFECT INSPECTION APPARATUS, SUBSTRATE BONDING APPARATUS, AND DEFECT INSPECTION METHOD**

(30) Priority: 25.03.2025 JP 2025050583
(71) Applicant: SCREEN Holdings Co., Ltd., Kyoto-shi, Kyoto 602-8585 (JP)
(72) Inventor: FURUYA, Yoshio, Kyoto-shi, Kyoto, 602-8585 (JP)
(74) Representative: Goddar, Heinz J.

(57) **Abstract**

A defect inspection apparatus (1) includes a heater unit (9) to emit infrared rays (F2) to a substrate (W) held by a substrate holding unit (8) and heat the substrate (W), an infrared camera (10) to face a first principal surface (Wa) of the substrate (W) and image an imaging region (24) on the first principal surface (Wa); a heat insulating member (31) to absorb the infrared rays (F2) emitted by the heater unit (9), and a heat insulating member moving unit (50) to move the heat insulating member (31) between a heat insulation position (P10) where the heat insulating member (31) and the imaging region (24) overlap each other when viewed from a normal direction (Z) of the first principal surface (Wa) and a retracted position (P2) where the heat insulating member (31) and the imaging region (24) do not overlap each other when viewed from the normal direction (Z). The substrate holding unit (8) may be positioned between the heater unit (9) and the infrared camera (10) in the normal direction (z).

## Description

### CROSS REFERENCE TO RELATED APPLICATIONS

This application claims priority based on Japanese Patent Application No. 2025-050583 filed on March 25, 2025, the entire contents of which are incorporated herein by reference.

### BACKGROUND OF THE INVENTION

### 1. Field of the Invention

The present invention relates to a defect inspection apparatus, a substrate bonding apparatus, and a defect inspection method.

### 2. Description of Related Art

A defect inspection apparatus disclosed in Japanese Patent Application Publication No. 2007-258555 includes an XY stage that holds a silicon wafer, a light source that irradiates the silicon wafer placed on the XY stage with infrared rays, and an infrared camera disposed on the XY stage. The light source is disposed below the silicon wafer. The infrared camera captures infrared light transmitted through the silicon wafer and images the silicon wafer. In the above defect inspection apparatus, the shape and in-plane position of the crystal defect included in the silicon wafer are detected based on an inspection image imaged by the infrared camera.

### SUMMARY OF THE INVENTION

In the defect inspection apparatus disclosed in Japanese Patent Application Publication No. 2007-258555, there is a possibility that a crystal defect cannot be satisfactorily detected even when the crystal defect is included in a target of imaging by the infrared camera depending on the type of the substrate to be inspected. That is, there is a possibility that the above defect inspection apparatus cannot accurately inspect whether or not there is a defect in an interior of the substrate.

An object of the present invention is to provide a defect inspection apparatus, a substrate bonding apparatus, and a defect inspection method capable of accurately inspecting whether or not there is a defect in an interior of a substrate.

A preferred embodiment of the present invention provides a defect inspection apparatus including: a substrate holding unit to hold a substrate having a first principal surface; a heater unit to emit infrared rays to the substrate held by the substrate holding unit and heat the substrate in a non-contact manner; an infrared camera to face the first principal surface of the substrate held by the substrate holding unit and image an imaging region on the first principal surface; a heat insulating member to absorb the infrared rays emitted by the heater unit; and a heat insulating member moving unit to move the heat insulating member between a heat insulation position where the heat insulating member and the imaging region overlap each other when viewed from a normal direction of the first principal surface and a retracted position where the heat insulating member and the imaging region do not overlap each other when viewed from the normal direction. The substrate holding unit is positioned between the heater unit and the infrared camera in the normal direction.

In a preferred embodiment of the present invention, the heat insulating member moving unit moves the heat insulating member in a first direction along the first principal surface of the substrate. The heat insulating member has a band shape extending along a second direction orthogonal to the first direction and along the first principal surface of the substrate.

In a preferred embodiment of the present invention, the heat insulating member has a length that is capable of overlapping an entire region of the substrate in the second direction.

In a preferred embodiment of the present invention, a first width of the heat insulating member in the first direction is wider than a region width of the imaging region in the first direction.

In a preferred embodiment of the present invention, the defect inspection apparatus further includes an imaging region moving unit to move the imaging region in the second direction in the first principal surface of the substrate.

In a preferred embodiment of the present invention, the heater unit has a heating surface to face an entire region of a second principal surface of the substrate opposite to the first principal surface.

In a preferred embodiment of the present invention, the heater unit is a resistance heating type heater unit.

In a preferred embodiment of the present invention, the retracted position includes a first retracted position retracted to one side in the first direction with respect to the heat insulation position and a second retracted position retracted to the other side in the first direction with respect to the heat insulation position. Then, the heat insulating member moving unit moves the heat insulating member between the first retracted position and the second retracted position along the first direction. Then, the infrared camera images the imaging region at a timing at which the heat insulating member moving between the first retracted position and the second retracted position is positioned at the heat insulation position.

In a preferred embodiment of the present invention, when the heat insulating member is at the retracted position, the heat insulating member is positioned between the substrate and the heater unit in the normal direction.

In a preferred embodiment of the present invention, the substrate includes a bonded substrate having a bonding interface.

A preferred embodiment of the present invention provides a substrate bonding apparatus including: a bonding unit that bonds two substrates; and the defect inspection apparatus to inspect the bonded substrate that is formed by bonding the two substrates by the bonding unit.

A preferred embodiment of the present invention provides a defect inspection method including: a substrate holding step of holding a substrate having a first principal surface; a heating step of emitting infrared rays from a heater unit and heating the substrate in a non-contact manner; a heat insulating member moving step of moving a heat insulating member capable of absorbing the infrared rays between a heat insulation position and a retracted position; a defect inspecting step of executing at least one of a first defect inspection of imaging an imaging region on the first principal surface by an infrared camera in a state where the heat insulating member is at the heat insulation position and a second defect inspection of imaging the imaging region on the first principal surface by the infrared camera in a state where the heat insulating member is at the retracted position; and a selecting step of selecting whether or not to execute each of the first defect inspection and the second defect inspection in the defect inspecting step. The heat insulation position is a position where the heat insulating member and the imaging region overlap each other when viewed from a normal direction of the first principal surface, and the retracted position is a position where the heat insulating member and the imaging region do not overlap each other when viewed from the normal direction.

The above and yet other objects, features, and effects of the present invention will become more apparent from the following description of the preferred embodiment made with reference to the attached drawings.

### BRIEF DESCRIPTION OF THE DRAWINGS

FIG. 1 is a schematic plan view of a defect inspection apparatus according to a preferred embodiment of the present invention.
FIG. 2 is a perspective view of a defect inspecting unit included in the defect inspection apparatus.
FIG. 3 is a schematic plan view of the defect inspecting unit.
FIG. 4 is a schematic sectional view of the defect inspecting unit taken along sectioning line IV-IV in FIG. 2.
FIG. 5 is a schematic sectional view of the defect inspecting unit taken along sectioning line V-V in FIG. 2.
FIG. 6 is a schematic enlarged sectional view for describing infrared rays taken into an infrared camera in a first defect inspection.
FIG. 7 is a schematic enlarged sectional view for describing infrared rays taken into an infrared camera in a second defect inspection.
FIG. 8 is a schematic view for describing the first defect inspection.
FIG. 9 is a schematic view for describing the second defect inspection.
FIG. 10 is a schematic view for describing the second defect inspection.
FIG. 11 is a flowchart illustrating a flow of a defect inspecting step executed by the defect inspecting unit.
FIG. 12 is a flowchart illustrating a flow of a first inspecting step (Step S11) illustrated in FIG. 11.
FIG. 13 is a schematic plan view for describing the first inspecting step.
FIGS. 14A to 14C are schematic sectional views for describing the first inspecting step.
FIGS. 15A to 15C are schematic sectional views illustrating a step subsequent to that of FIG. 14C.
FIG. 16 is a schematic plan view for describing the first inspecting step.
FIG. 17 is a schematic plan view for describing a second inspecting step.
FIG. 18 is a flowchart illustrating a flow of a defect inspecting step according to a first modification example in which an inspection order is changed.
FIG. 19 is a diagram illustrating an example of an operation screen displayed on a display unit illustrated in FIG. 1.
FIG. 20A is a plan view for describing a second modification example in which a defect inspecting unit includes a cooling unit.
FIG. 20B is a plan view for describing a third modification example in which a defect inspecting unit includes a cooling unit.
FIG. 21 is a schematic top view of a substrate bonding apparatus including a defect inspecting unit.

### DETAILED DESCRIPTION OF THE EXAMPLE EMBODIMENTS

A preferred embodiment of the present invention shall now be described with reference to the attached drawings. In the following description, identical reference signs are given to corresponding structures among the accompanying drawings, and duplicate descriptions thereof shall be omitted or simplified. For the structures whose description have been omitted or simplified, the description given before the omission or simplification shall apply.

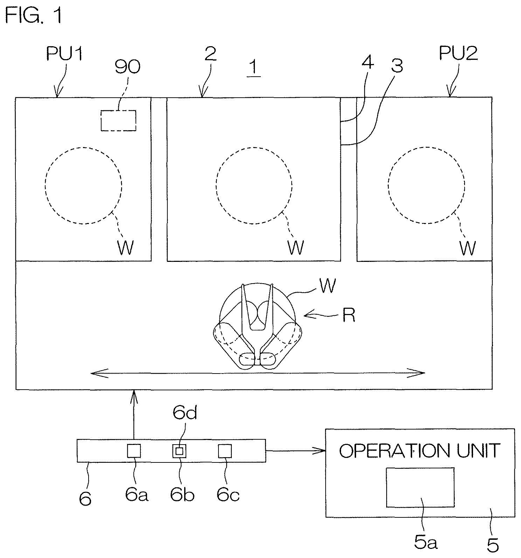

FIG. 1 is a schematic plan view of a defect inspection apparatus 1 according to a preferred embodiment of the present invention.

The defect inspection apparatus 1 includes a defect inspecting unit 2, a carry-in unit PU1, a carry-out unit PU2, and a transfer robot R. The defect inspecting unit 2 is a unit that inspects bonded substrate W to be inspected. The bonded substrate W is an example of a substrate to be inspected by the defect inspection apparatus 1. The defect inspecting unit 2 includes a housing 4 having a partition wall 3.

The carry-in unit PU1 is a unit for carrying the bonded substrate W to be inspected by the defect inspecting unit 2 into the defect inspection apparatus 1. A substrate container that houses a plurality of bonded substrates W to be inspected may be placed on the carry-in unit PU1. The carry-out unit PU2 is a unit for carrying the bonded substrate W inspected by the defect inspecting unit 2 out from the defect inspection apparatus 1. A substrate container that houses a plurality of inspected bonded substrates W may be placed on the carry-out unit PU2. The transfer robot R transfers the bonded substrate W between the carry-in unit PU1 and the defect inspecting unit 2. The transfer robot R transfers the bonded substrate W between the defect inspecting unit 2 and the carry-out unit PU2.

The defect inspection apparatus 1 includes an operation unit 5 for a user to operate the defect inspection apparatus 1. The operation unit 5 includes a display unit 5a that displays information related to defect inspection. The display unit 5a may include a monitor. The operation unit 5 may further have an input unit for the user to input information related to the defect inspection. The input unit may include a keyboard. The operation unit 5 may be a touch panel. In this case, the display unit 5a and the input unit are integrated.

The defect inspection apparatus 1 includes a controller 6 that controls electric equipment and electronic equipment provided in the defect inspection apparatus 1. The controller 6 includes a CPU (central processing unit, processor) 6a that executes processing of information such as execution of a program, and a memory 6b that stores information such as a program to be executed by the CPU 6a. The controller 6 further includes a communication module 6c that executes at least one of transmission of information transmitted from the CPU 6a or the memory 6b to a device other than the controller 6, and reception of receiving information transmitted from a device other than the controller 6 and transmitting the information to the CPU 6a or the memory 6b. The controller 6 controls the defect inspection apparatus 1 to inspect the bonded substrate W, which is an example of an object. In other words, the controller 6 is programmed to execute inspection, etc., of the bonded substrate W described below.

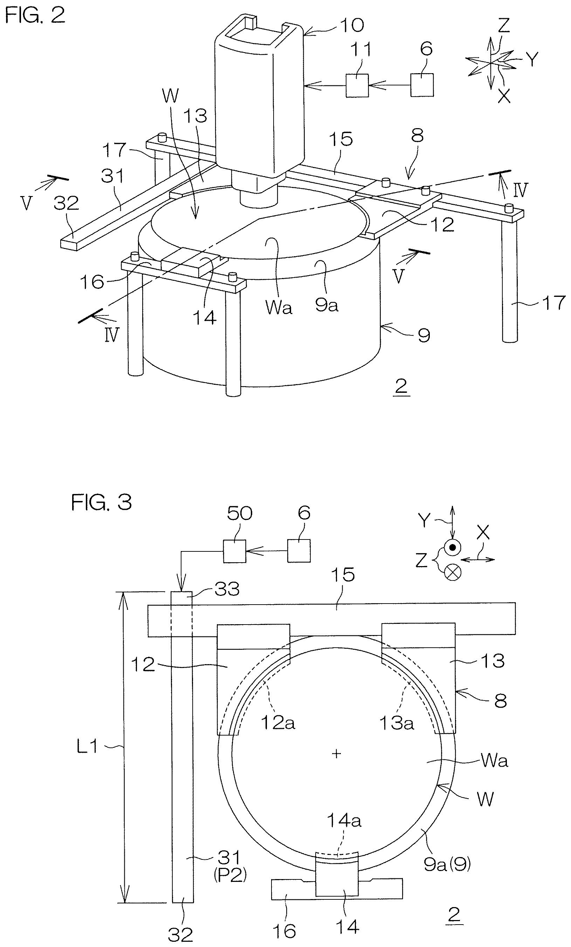

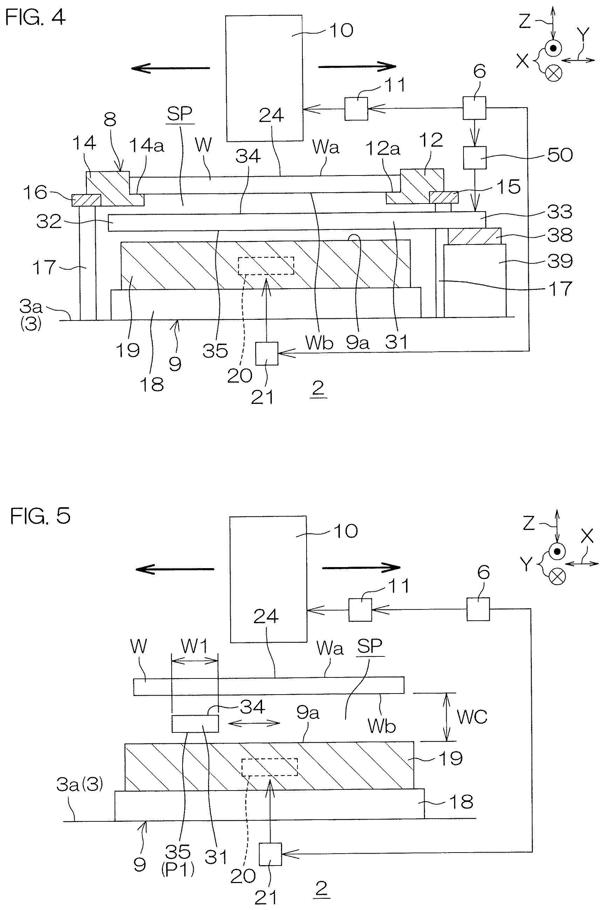

FIG. 2 is a perspective view of the defect inspecting unit 2 illustrated in FIG. 1. FIG. 3 is a schematic plan view of the defect inspecting unit 2. FIG. 4 is a schematic sectional view of the defect inspecting unit 2 taken along sectioning line IV-IV in FIG. 2. FIG. 5 is a schematic sectional view of the defect inspecting unit 2 taken along sectioning line V-V in FIG. 2. For simplification of illustration, illustration of a support rail 38 and a support base 39 is omitted in FIGS. 2 and 3, and illustration of an infrared camera 10 is omitted in FIG. 3.

The defect inspecting unit 2 is a device that non-destructively inspects whether or not there is a defect in the inspection object. FIGS. 1 and 2 illustrate an example in which the inspection object is the bonded substrate W. The bonded substrate W is an example of a substrate to be inspected by the defect inspection apparatus 1. The defect inspecting unit 2 may detect the position, size, shape, and the number of defects in addition to the presence or absence of defect. In the present Description, unless otherwise specified, each operation of the defect inspecting unit 2 is executed under the control of the controller 6.

Referring to FIGS. 2 to 5, the defect inspecting unit 2 includes a substrate holding unit 8 that holds, in the housing 4, the bonded substrate W to be inspected, a heater unit 9 that heats the bonded substrate W from below in a non-contact manner, the infrared camera 10 that faces a first principal surface Wa of the bonded substrate W and images the bonded substrate W held by the substrate holding unit 8, and a camera moving unit 11 (imaging moving actuator) for moving the infrared camera 10 with respect to the substrate holding unit 8 and the heater unit 9. The camera moving unit 11 is an example of an imaging region moving unit for moving, on the first principal surface Wa of the bonded substrate W, an imaging region 24.

The substrate holding unit 8 supports the bonded substrate W to be inspected in a horizontal orientation. The substrate holding unit 8 contactingly supports the bonded substrate W from below. The substrate holding unit 8 may be referred to as a "substrate holder." Hereinafter, a normal direction Z of the first principal surface Wa of the bonded substrate W held by the substrate holding unit 8 coincides with the vertical direction. The normal direction Z is a direction (vertical direction) perpendicular to the first principal surface Wa. Hereinafter, the vertical direction is referred to at times as a "vertical direction Z."

Referring to FIGS. 2 to 4, the substrate holding unit 8 includes a first support member 12 that supports a peripheral edge portion of the bonded substrate W, a second support member 13 that supports the peripheral edge portion of the bonded substrate W, and a third support member 14 that supports the peripheral edge portion of the bonded substrate W. The first support member 12, the second support member 13, and the third support member 14 are separated from each other in at least one of a first direction X and a second direction Y. In this preferred embodiment, the first support member 12, the second support member 13, and the third support member 14 are separated in a circumferential direction of the bonded substrate W. As illustrated in FIG. 3, the first support member 12 has a horizontal first support surface 12a that contactingly supports the peripheral edge portion of the bonded substrate W from below. The second support member 13 has a horizontal second support surface 13a that contactingly supports the peripheral edge portion of the bonded substrate W from below. The third support member 14 has a horizontal third support surface 14a that contactingly supports the peripheral edge portion of the bonded substrate W from below.

The substrate holding unit 8 further includes a first horizontal rod 15 extending along a horizontal direction. The substrate holding unit 8 supports the first support member 12 and the second support member 13 from below. The first horizontal rod 15 may extend along the first direction X. The substrate holding unit 8 further includes a second horizontal rod 16 extending along the horizontal direction. The substrate holding unit 8 supports the third support member 14 from below. The second horizontal rod 16 may extend along the first direction X. The first horizontal rod 15 and the second horizontal rod 16 are coupled to a plurality of pillars 17 extending in the vertical direction Z from a bottom wall 3a (see FIGS. 4 and 5) included in the partition wall 3. The plurality of pillars 17 support the first support member 12, the second support member 13, the third support member 14, the first horizontal rod 15, and the second horizontal rod 16 at positions spaced upward from the bottom wall 3a included in the partition wall 3.

The heater unit 9 heats an entirety of the bonded substrate W. The heater unit 9 has a form of a disk-shaped hot plate. The form of the heater unit 9 is not limited to the disk shape, and may be another shape (for example, a rectangular plate shape).

Referring to FIGS. 4 and 5, the heater unit 9 includes a plate main body 19 and a heater 20. The plate main body 19 is larger than the bonded substrate W in plan view. Specifically, a width of the plate main body 19 in the first direction X and the second direction Y is larger than a width of the bonded substrate W in the first direction X and the second direction Y. An upper surface of the plate main body 19 constitutes a heating surface 9a. The heater 20 may be a resistor built in the plate main body 19. By energizing the heater 20, the heating surface 9a is heated. By energizing the heater 20, the heating surface 9a generates heat. Power is supplied from a heater energizing unit 21 to the heater 20. The heater 20 can heat the bonded substrate W to a temperature substantially equal to the temperature of the heater 20. The heater 20 is arranged such as to be able to heat the bonded substrate W in a temperature range of not lower than ordinary temperature (for example, a temperature of not lower than 5°C and not higher than 25°C) and not higher than 400°C. The controller 6 is connected to the heater energizing unit 21.

As described above, the heater 20 is a resistor. That is, the heater unit 9 is a resistance heating type heater unit. The heater unit 9 may include an infrared lamp instead of the heater 20. The infrared lamp may include at least one of a xenon lamp and a halogen lamp.

The heater unit 9 further includes a support body 18 that supports the plate main body 19 from below. The support body 18 is disposed on the bottom wall 3a of the partition wall 3. The support body 18 is formed using a member having a heat insulating property. The plate main body 19 is thermally insulated from the bottom wall 3a by the support body 18. Instead of the arrangement in which the support body 18 is provided, the arrangement may be such that the plate main body 19 is supported from below by a plurality of pillars, and the plate main body 19 and the bottom wall 3a may be thermally insulated by a space formed between the plate main body 19 and the bottom wall 3a.

Referring to FIGS. 2 to 5, the infrared camera 10 is a camera that detects a temperature of an object by an infrared sensor and generates an image indicating a temperature distribution of the object. More specifically, the infrared camera 10 is a camera that measures the intensity of infrared rays emitted from an object, converts the measured intensity of infrared rays into the temperature of the object, and generates an image indicating the temperature distribution of the object. The infrared camera 10 may be referred to as a thermal camera or thermography. The infrared camera 10 images the bonded substrate W heated by the heater unit 9. The infrared camera 10 is disposed such as to sandwich the bonded substrate W held by the substrate holding unit 8 between the infrared camera 10 and the heater unit 9. The infrared camera 10 images the bonded substrate W held by the substrate holding unit 8. Specifically, the infrared camera 10 images the imaging region 24 set on the bonded substrate W. More specifically, the infrared camera 10 images the imaging region 24 set on the first principal surface Wa of the bonded substrate W.

The camera moving unit 11 supports the infrared camera 10. The camera moving unit 11 holds the infrared camera 10 above the bonded substrate W held by the substrate holding unit 8. The camera moving unit 11 horizontally moves the infrared camera 10. The camera moving unit 11 may include an actuator. The actuator may include a motor.

The camera moving unit 11 holds the infrared camera 10 above the bonded substrate W held by the substrate holding unit 8. The camera moving unit 11 horizontally moves the infrared camera 10. The camera moving unit 11 may include an actuator. The actuator may include a motor. The camera moving unit 11 moves the infrared camera 10 in at least one of the first direction X and the second direction Y. The camera moving unit 11 is connected to the controller 6.

The defect inspecting unit 2 further includes a heat insulating member 31 for thermally insulating the imaging region 24 set on the bonded substrate W from the heater unit 9. The heat insulating member 31 can absorb infrared rays emitted from the heater unit 9.

Referring to FIG. 3, the heat insulating member 31 is a band-shaped member extending in the second direction Y. The heat insulating member 31 has a length L1 that can overlap an entire region of the bonded substrate W in the second direction Y. The length L1 of the heat insulating member 31 is larger than a diameter of the bonded substrate W held by the substrate holding unit 8. The heat insulating member 31 has a first end portion 32 and a second end portion 33 in the second direction Y. The first end portion 32 is closer to one side in the second direction Y than an end portion on one side (lower side in FIG. 3) in the second direction Y of the bonded substrate W held by the substrate holding unit 8. The second end portion 33 is closer to the other side in the second direction Y than an end portion on the other side in the second direction Y (upper side in FIG. 3) of the bonded substrate W held by the substrate holding unit 8.

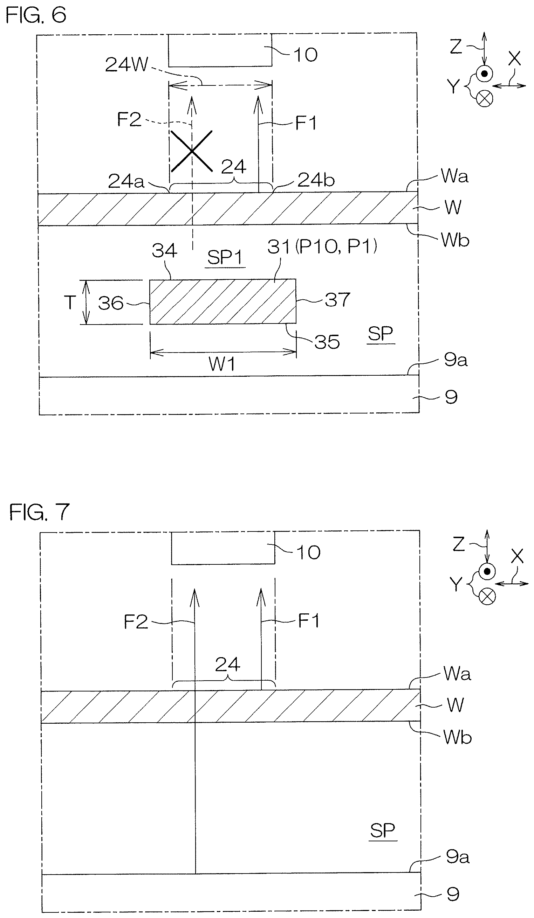

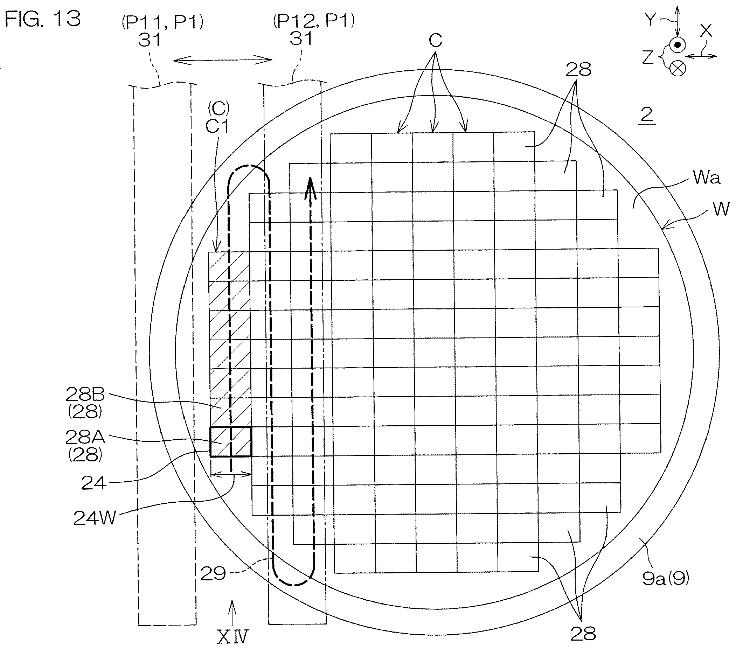

Referring to FIG. 5, the cross-sectional shape of the heat insulating member 31 has a rectangular shape that is long in the first direction X. The heat insulating member 31 has a flat plate shape. A first width W1 of the heat insulating member 31 in the first direction X may be narrower than the diameter of the bonded substrate W. The first width W1 of the heat insulating member 31 in the first direction X may be narrower than a radius of the bonded substrate W. The first width W1 may be wider than a region width 24W (FIGS. 6 and 13) of the imaging region 24 to be described later. The first width W1 may be narrower than twice the region width 24W.

Referring to FIGS. 4 and 5, the heat insulating member 31 has a substrate facing surface 34 to face a second principal surface Wb of the bonded substrate W held by the substrate holding unit 8, and a heater facing surface 35 facing the heating surface 9a of the heater unit 9. The substrate facing surface 34 is a horizontal plane. The heater facing surface 35 is a horizontal plane.

The heat insulating member 31 is formed of a metal material. Specifically, the metal material used for the heat insulating member 31 is preferably a material having a high infrared ray emissivity. The infrared ray emissivity of the heat insulating member 31 may be not less than 0.5 and not more than 1.0. It is preferable that the infrared ray emissivity of the heat insulating member 31 is not less than 0.7 and not more than 1.0. It is particularly preferable that the infrared ray emissivity of the heat insulating member 31 is not less than 0.8 and not more than 1.0. The metal material used for the heat insulating member 31 contains at least one type among aluminum, an aluminum alloy, steel, iron, titanium, copper, chromium, nichrome, molybdenum, and tungsten. Since the heat insulating member 31 is formed using a metal material having a high emissivity, it is possible to effectively block infrared rays from the heater unit 9 from reaching the bonded substrate W. It is thereby possible to satisfactorily insulate the heat insulating member 31 from the heater unit 9.

The heat insulating member 31 may be formed using a material other than the metal material. In this case, the heat insulating member 31 may be formed using a resin material. It is preferable that the resin material has a heat resistance property and high infrared ray emissivity as described above.

Referring to FIG. 4, the heat insulating member 31 is supported from below by the support rail 38 extending in the first direction X in a region near the second end portion 33. The heat insulating member 31 is supported by the support rail 38 such as to be movable in the first direction X. The support rail 38 is supported from below by the support base 39 disposed on the bottom wall 3a of the partition wall 3.

Referring to FIGS. 3 and 4, the defect inspecting unit 2 further includes a heat insulating member moving unit 50 (heat insulation moving actuator) for moving the heat insulating member 31 in the first direction X. The heat insulating member moving unit 50 may include an actuator. The actuator may include a motor. The heat insulating member moving unit 50 moves the heat insulating member 31 in the first direction X between an inspection position P1 (FIG. 5) and a heater retracted position P2 (FIG. 3). The inspection position P1 is set in a facing space SP (FIG. 4) sandwiched between the heater unit 9 and the bonded substrate W held by the substrate holding unit 8. In a state where the heat insulating member 31 is positioned at the inspection position P1, at least a portion of the heater facing surface 35 of the heat insulating member 31 faces the heating surface 9a (FIG. 4) of the heater unit 9 in the vertical direction Z. In other words, the inspection position P1 is such a position that at least a portion of the heat insulating member 31 positioned at the inspection position P1 is included in the facing space SP sandwiched between the heater unit 9 and the bonded substrate W.

The heater retracted position P2 (FIG. 3) is set outside the facing space SP. In a state where the heat insulating member 31 is positioned at the heater retracted position P2, the heater facing surface 35 of the heat insulating member 31 does not face the heating surface 9a of the heater unit 9 in the vertical direction Z. In other words, the heater retracted position P2 is a position where the heat insulating member 31 positioned at the heater retracted position P2 does not face the heater unit 9. The heater retracted position P2 is retracted laterally with respect to a first space SP1. The heater retracted position P2 is an example of the retracted position.

The defect inspection on the bonded substrate W includes defect determination of determining whether or not there is a defect in the bonded substrate W based on the image generated by the infrared camera 10. An interior of the bonded substrate W includes a bonding interface Wd to be described later. The controller 6 may store a defect determination application program 6d (FIG. 1) that executes defect determination. In addition to or instead of executing the defect determination by the controller 6, the defect determination may be executed by a device other than the controller 6. In this case, the controller 6 may store the image generated by the infrared camera 10 in the memory 6b. In the present preferred embodiment, whether or not there is a defect in the imaging region 24 may be determined for each imaging region 24.

Next, the bonded substrate W to be inspected shall be described.

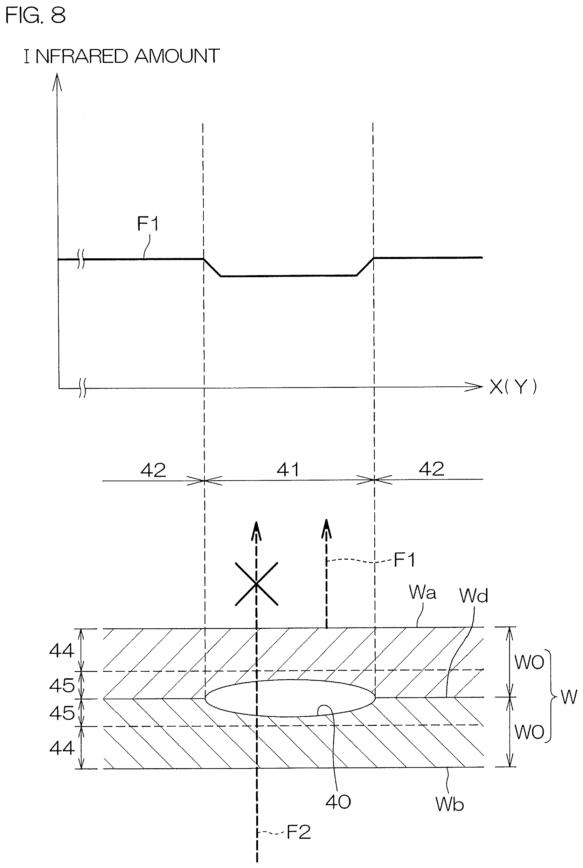

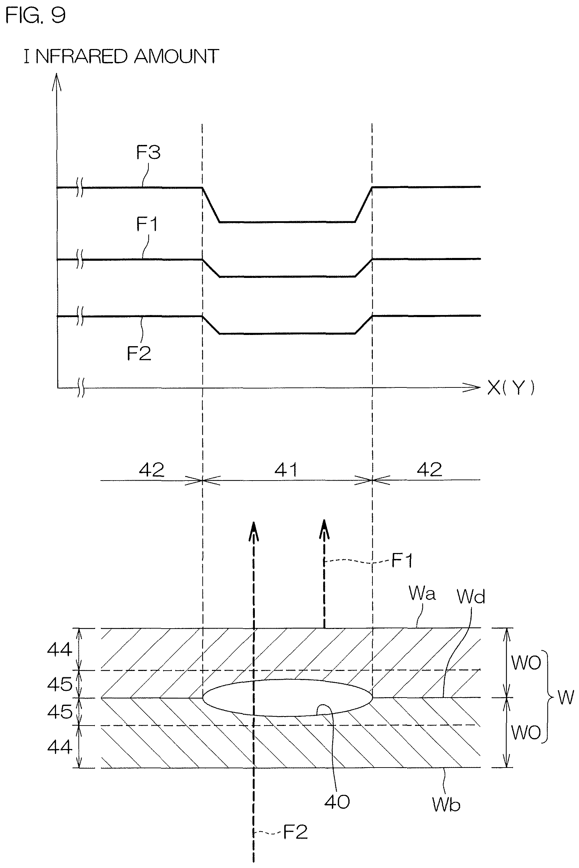

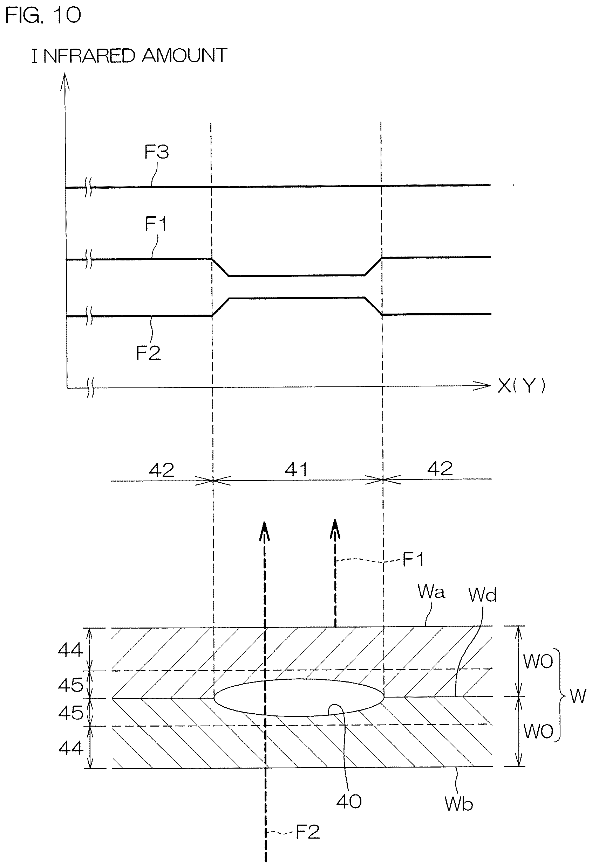

FIG. 6 is a schematic enlarged sectional view for describing infrared rays taken into the infrared camera 10 in a first defect inspection. FIG. 7 is a schematic enlarged sectional view for describing infrared rays taken into the infrared camera 10 in a second defect inspection. FIG. 8 is a schematic view for describing the first defect inspection. FIGS. 9 and 10 are schematic views for describing the second defect inspection.

Referring to the lower portion of each drawing included in FIGS. 8 to 10, the bonded substrate W has the first principal surface Wa and the second principal surface Wb. The bonded substrate W is two bonded substrates WO. The substrates WO may be any of semiconductor wafers, substrates for FPDs (flat panel displays) such as liquid crystal display devices, organic EL (electroluminescence) display devices, etc., substrates for optical disks, substrates for magnetic disks, substrates for magnetooptical disks, substrates for photomasks, ceramic substrates, and substrates for solar cells, or may be other than these.

The two bonded substrates WO are, for example, two circular substrates having the same diameter, which are bonded in parallel such that their centers coincide with each other. At least one of the shape and the size of the bonded two substrates WO may be different from each other. The substrates WO may be a patterned substrate on which a structure such as a pattern or a semiconductor device is formed, or may be a non-patterned substrate on which a structure is not formed. In a case where one of the two substrates WO is a patterned substrate, the other of the two substrates WO may be either a patterned substrate or a non-patterned substrate. The material of the substrates WO (the material of a base material in a case where a structure is formed on a front surface of the base material. The same applies hereinafter.) may be a semiconductor material or may be a material other than the semiconductor material. The material of one of the substrates WO may be the same as or different from the material of the other of the substrates WO. The semiconductor material is, for example, silicon.

The two substrates WO are bonded in a state where the bonding surfaces of the two substrates WO are in contact with each other. The bonding surface of the two bonded substrates WO corresponds to an interface between the two bonded substrates WO. That is, the bonded substrate W has the bonding interface Wd. The bonding surface may be formed on a front surface of a coating film 45 that coats a front surface of a substrate main body 44 in the substrates WO. The coating film 45 may include at least one of a metal film and an insulating film (for example, an oxide film, a nitride film, an oxynitride film, etc.). A portion having a defect such as a void 40 (cavity) in the bonding interface Wd of the bonded substrate W is defined as a defect portion 41, and a portion having no defect such as the void 40 in the bonding interface Wd is defined as a sound portion 42, respectively. The defect portion 41 is a portion overlapping the void 40 when viewed in a direction perpendicular to the first principal surface Wa of the bonded substrate W.

Even when the amount of heat per unit volume given to the defect portion 41 and the sound portion 42 is the same, the defect portion 41 shows a change in temperature different from that of the sound portion 42. That is, the defect portion 41 and the sound portion 42 have different specific heat. In a case where the bonded substrate W has the defect portion 41, when the bonded substrate W is heated, a temperature distribution is generated on the first principal surface Wa of the bonded substrate W. This temperature distribution is generated due to a difference between the specific heat of the defect portion 41 and the specific heat of the sound portion 42. For example, in a case where the defect portion 41 includes the void 40, since the void 40 is less likely to store heat, the defect portion 41 has a lower temperature than the sound portion 42 on the first principal surface Wa. Therefore, it is possible to inspect whether or not there is a defect such as the void 40 by detecting the temperature distribution of the heated first principal surface Wa of the bonded substrate W.

Referring to FIGS. 6 and 7, the heater unit 9 emits infrared rays (second infrared ray F2 to be described later) toward the bonded substrate W held by the substrate holding unit 8 and heats the bonded substrate W. Since the heating surface 9a of the heater unit 9 faces an entire region of the second principal surface Wb of the bonded substrate W, the entire region of the bonded substrate W can be uniformly heated by the heater unit 9. Since the resistance heating type heater unit is used as the heater unit 9, the amount of heat generated from the heating surface 9a can be kept uniform. It is thereby possible to uniformly heat the entire region of the bonded substrate W.

After the bonded substrate W is sufficiently heated by the heater unit 9, the infrared camera 10 images the imaging region 24 set on the bonded substrate W. The imaging region 24 is a region in a range that can be imaged by one imaging by the infrared camera 10 in the bonded substrate W. The imaging region 24 may be referred to as an "imaging field of view." As shall be described later with reference to FIG. 13, etc., the imaging region 24 may have a rectangular shape or may have a shape other than the rectangular shape.

The Infrared camera 10 images the imaging region 24, and generates an image indicating a temperature distribution of the imaging region 24. In a case where a defect such as the void 40 exists at a position overlapping the imaging region 24 when viewed from a direction perpendicular or substantially perpendicular to the first principal surface Wa of the bonded substrate W, when the imaging region 24 is heated, a position in the imaging region 24 overlapping the defect shows a temperature change different from other positions in the imaging region 24. Therefore, whether or not there is a defect in the imaging region 24 can be determined based on the image generated by the infrared camera 10. Further, in a case where there are defects, the position, size, shape, and the number of defects can be identified or measured based on the same image.

The defect inspecting unit 2 can execute two types of defect inspection including the first defect inspection and the second defect inspection. The first defect inspection and the second defect inspection are selectively executed (selecting step).

Referring to FIG. 6, in the first defect inspection, the controller 6 controls the infrared camera 10 to image the imaging region 24 in a state where the heat insulating member 31 is positioned at a heat insulation position P10 set in the first space SP1 sandwiched between the imaging region 24 and the heater unit 9 (imaging step).

The heat insulation position P10 is a position of the heat insulating member 31 that overlaps the imaging region 24 when viewed from the normal direction Z of the first principal surface Wa of the bonded substrate W. In other words, the heat insulation position P10 is a position where the heat insulating member 31 and the imaging region 24 overlap each other when viewed from the normal direction Z of the first principal surface Wa of the bonded substrate W. The heat insulation position P10 is a position included in the inspection position P1. In FIG. 6, "31 (P10, P1)" indicates that the heat insulating member 31 is positioned at the heat insulation position P10, and the heat insulation position P10 is included in the inspection position P1.

As described above, the first width W1 of the heat insulating member 31 in the first direction X is wider than the region width 24W of the imaging region 24 in the first direction X. And, in a state where the heat insulating member 31 is positioned at the heat insulation position P10, a third end portion 36 on one side (left side in FIG. 6) in the first direction X of the heat insulating member 31 protrudes to one side in the first direction X from one end portion 24a on one side in the first direction X of the imaging region 24. Also, in this state, a fourth end portion 37 on the other side (right side in FIG. 6) in the first direction X of the heat insulating member 31 protrudes to the other side in the first direction X from another end portion 24b on the other side in the first direction X of the imaging region 24.

Referring to FIG. 6, infrared rays to be imaged by the infrared camera 10 are both a first infrared ray F1 and the second infrared ray F2, or only the first infrared ray F1. The first infrared ray F1 is an infrared ray emitted from the bonded substrate W. The second infrared ray F2 is an infrared ray emitted from the heater unit 9. In the state where the heat insulating member 31 is positioned at the heat insulation position P10, the imaging region 24 is thermally insulated from the heater unit 9 by the heat insulating member 31. At this time, the second infrared ray F2 is blocked by the heat insulating member 31 and does not reach the imaging region 24. Therefore, the second infrared ray F2 is not transmitted through the imaging region 24 of the bonded substrate W. At this time, only the first infrared ray F1 among the infrared rays to be imaged is taken into the infrared camera 10. In other words, in the first defect inspection, the infrared camera 10 does not take in the second infrared ray F2 transmitted through the imaging region 24 of the bonded substrate W.

Referring to FIG. 8, the total amount of infrared rays taken into the infrared camera 10 in the first defect inspection substantially matches the amount of the first infrared ray F1. That is, the infrared camera 10 generates an image indicating the temperature distribution of the imaging region 24 based only on the first infrared ray F1 emitted from the imaging region 24 (bonded substrate W). The image generated based only on the first infrared ray F1 indicates a temperature difference between the sound portion 42 and the defect portion 41 of the imaging region 24.

In a case where the defect portion 41 is a void, the amount of the first infrared ray F1 emitted from the defect portion 41 on the first principal surface Wa is smaller than the amount of the first infrared ray F1 emitted from the sound portion 42 on the first principal surface Wa. Therefore, it is possible to determine whether or not there is the void 40 in the imaging region 24 based on the image generated by the infrared camera 10.

Referring to FIG. 7, in the second defect inspection, the controller 6 does not allow the heat insulating member 31 to be positioned in the first space SP1 sandwiched between the imaging region 24 and the heater unit 9. In this state, the controller 6 controls the infrared camera 10 to image the imaging region 24.

In the state where the heat insulating member 31 does not exist in the first space SP1, the second infrared ray F2 reaches the imaging region 24 of the bonded substrate W. At this time, the second infrared ray F2 transmitted through the imaging region 24 of the bonded substrate W is transmitted through the imaging region 24 (bonded substrate W) and taken into the infrared camera 10. As a matter of course, the first infrared ray F1 emitted from the imaging region 24 is also taken into the infrared camera 10. That is, in the second defect inspection, the infrared camera 10 takes in both the first infrared ray F1 emitted from the imaging region 24 and the second infrared ray F2 transmitted through the imaging region 24.

The first infrared ray F1 and the second infrared ray F2 taken into the infrared camera 10 are collectively referred to as a third infrared ray F3. Referring to FIGS. 9 and 10, in the second defect inspection, the infrared camera 10 generates an image indicating the temperature distribution of the imaging region 24 based on the amount of the third infrared ray F3 taken into the infrared camera 10. The amount of the third infrared ray F3 taken into the infrared camera 10 is an amount obtained by adding the amount of the first infrared ray F1 and the amount of the second infrared ray F2 taken into the infrared camera 10. That is, the infrared camera 10 generates an image indicating the temperature distribution of the imaging region 24 based on both the first infrared ray F1 emitted from the imaging region 24 and the second infrared ray F2 transmitted through the imaging region 24 of the bonded substrate W. Therefore, the temperature distribution generated by the infrared camera 10 is not the temperature distribution itself of the imaging region 24 (bonded substrate W) but the temperature distribution affected by the second infrared ray F2 transmitted through the imaging region 24 of the bonded substrate W.

As illustrated in FIG. 9, when the first principal surface Wa is viewed in plan view from the normal direction Z, there are cases where the amount of the second infrared ray F2 emitted from the region overlapping the defect portion 41 on the first principal surface Wa is smaller than the amount of the second infrared ray F2 emitted from the region overlapping the sound portion 42 on the first principal surface Wa. In this case, when the infrared camera 10 generates an image based on both the first infrared ray F1 and the second infrared ray F2, the image indicates the temperature difference between the sound portion 42 and the defect portion 41 of the imaging region 24.

The bonded substrate W includes a single-layer or multi-layer film, etc., along the normal direction Z. During a period from when the second infrared ray F2 is emitted from the heater unit 9 to when the second infrared ray F2 reaches the infrared camera 10, the second infrared ray F2 is transmitted through the single-layer or multi-layer film described above. Therefore, the intensity of the second infrared ray F2 transmitted through the imaging region 24 of the bonded substrate W depends on an optical constant of each layer and a thickness of each layer. The optical constant of each layer is, for example, transmittance of infrared rays. The intensity of the second infrared ray F2 transmitted through the imaging region 24 of the bonded substrate W is proportional to the infrared ray transmittance of the material constituting the bonded substrate W.

On the other hand, as illustrated in FIG. 10, depending on the type of the bonded substrate W (the material of the bonded substrate W (particularly, the material of the coating film 45)), when the first principal surface Wa is viewed in plan view from the normal direction Z, there are cases where the amount of the second infrared ray F2 emitted from the region overlapping the defect portion 41 on the first principal surface Wa is larger than the amount of the second infrared ray F2 emitted from the region overlapping the sound portion 42 on the first principal surface Wa. In this case, when the first principal surface Wa is viewed in plan view from the normal direction Z, there are cases where the difference between the amount of the third infrared ray F3 emitted from the region overlapping the defect portion 41 on the first principal surface Wa (the sum of the amount of the first infrared ray F1 and the amount of the second infrared ray F2) and the amount of the third infrared ray F3 emitted from the region overlapping the sound portion 42 on the first principal surface Wa (the sum of the amount of the first infrared ray F1 and the amount of the second infrared ray F2) does not become large (in the example of FIG. 10, there is almost no difference.). In this case, when an image is generated based on the third infrared ray F3 (the sum of the first infrared ray F1 and the second infrared ray F2) emitted from the defect portion 41 on the first principal surface Wa, the image does not indicate the temperature difference between the sound portion 42 and the defect portion 41.

That is, in the second defect inspection, depending on the type of the bonded substrate W (the material of the bonded substrate W), the image generated by the infrared camera 10 may indicate the temperature difference between the sound portion 42 and the defect portion 41 in the imaging region 24, or the image generated by the infrared camera 10 may not indicate the temperature difference between the sound portion 42 and the defect portion 41 in the imaging region 24.

Hereinafter, a flow of defect inspection of the bonded substrate W by the defect inspecting unit 2 shall be described.

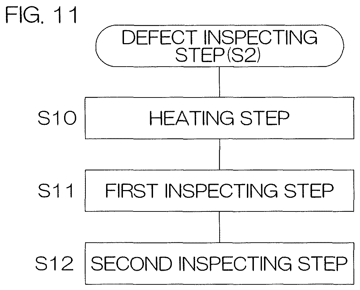

FIG. 11 is a flowchart illustrating a flow of the defect inspecting step (Step S2) executed by the defect inspecting unit 2.

The memory 6b (FIG. 1) of the controller 6 stores information on whether or not to execute a first inspecting step (Step S11) in the defect inspecting step (Step S2), information on whether or not to execute a second inspecting step (Step S12), and information on the execution order of the steps when the steps are both executed. At the start timing, the CPU 6a (FIG. 1) of the controller 6 selects, based on the information stored in the memory 6b, which of the first inspecting step (Step S11) and the second inspecting step (Step S12) to execute (selecting step). In other words, the controller 6 (CPU 6a) selects whether or not to execute each of the first inspecting step (Step S11) and the second inspecting step (Step S12). Then, the controller 6 (CPU 6a) executes the selected inspecting step (one of the first inspecting step (Step S11) and the second inspecting step (Step S12)).

In the example of FIG. 11, information indicating that both the first inspecting step (Step S11) and the second inspecting step (Step S12) are to be executed is stored in the memory 6b of the controller 6, and information indicating that the first inspecting step (Step S11) and the second inspecting step (Step S12) are to be executed in this order is stored. Therefore, the CPU 6a (FIG. 1) of the controller 6 selects the first inspecting step (Step S11) as the inspecting step to be executed.

Referring to FIG. 11, in the defect inspecting step (Step S2), the controller 6 executes a heating step (Step S10), the first inspecting step (Step S11), and the second inspecting step (Step S12) in this order.

Referring to FIGS. 2, 3, and 11, when the defect inspecting step (Step S2 in FIG. 11) is executed on the bonded substrate W by the defect inspecting unit 2, the uninspected bonded substrate W is taken out from the carry-in unit PU1 (FIG. 1) and carried into the housing 4 (FIG. 1) of the defect inspecting unit 2. The bonded substrate W carried into the defect inspecting unit 2 is held in a horizontal orientation by the substrate holding unit 8 with the first principal surface Wa facing upward (substrate holding step). When the bonded substrate W is carried in, the heat insulating member 31 is disposed at the heater retracted position P2 (FIG. 3). When the bonded substrate W is carried in, the infrared camera 10 is retracted laterally from the upper position of the bonded substrate W.

After the bonded substrate W is held by the substrate holding unit 8, the controller 6 executes the heating step (Step S10 in FIG. 11). The heating step (Step S10) is a step of heating the bonded substrate W in a non-contact manner by the heater unit 9. In the heating step (Step S10), the controller 6 controls the heater energizing unit 21 and heats the heater 20. Thereby, the heating surface 9a of the heater unit 9 generates heat, and the bonded substrate W is heated by the heating surface 9a maintained at a predetermined heating temperature.

When the bonded substrate W is continuously heated, the bonded substrate W is eventually brought into a thermal equilibrium state. In other words, the entire region of the bonded substrate W is brought into a thermal equilibrium state. At least one of a heating temperature of the heating surface 9a in the heating step (Step S10) and a heating time in the heating step (Step S10) is determined such that the entire region of the bonded substrate W heated in the heating step (Step S10) is brought into a thermal equilibrium state.

When the heating time elapses from when the bonded substrate W is held by the substrate holding unit 8, the controller 6 executes the first inspecting step (Step S11 in FIG. 11) while continuing heating by the heater unit 9. The first inspecting step (Step S11) is a step of inspecting the bonded substrate W by executing the first defect inspection (FIGS. 6 and 8) described above. The first inspecting step is started in a state where the bonded substrate W is in the thermal equilibrium state. Although heating by the heater unit 9 is continued even after the first inspecting step (Step S11) is started, since the bonded substrate W is already in the thermal equilibrium state, the temperature of the bonded substrate W no longer rises.

Referring to FIGS. 2, 4, 5, and 11, before the start of the first inspecting step (Step S11), the infrared camera 10 is led out to the position above the bonded substrate W. In the first inspecting step (Step S11), the controller 6 controls the camera moving unit 11 and moves the infrared camera 10 such that the imaging region 24 on the first principal surface Wa is disposed in an imaging target region 28 to be described later. Also, in the first inspecting step (Step S11), the controller 6 controls the infrared camera 10 to image the imaging region 24 set on the bonded substrate W.

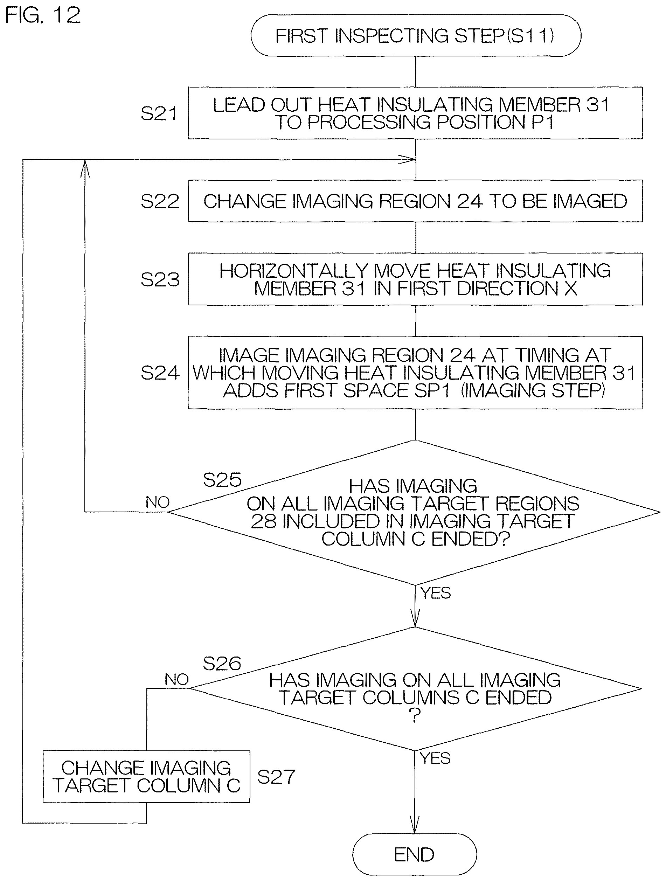

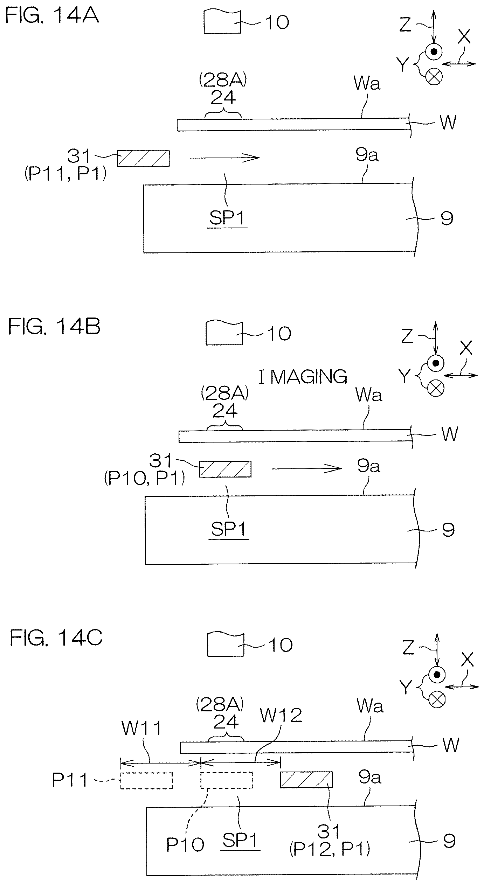

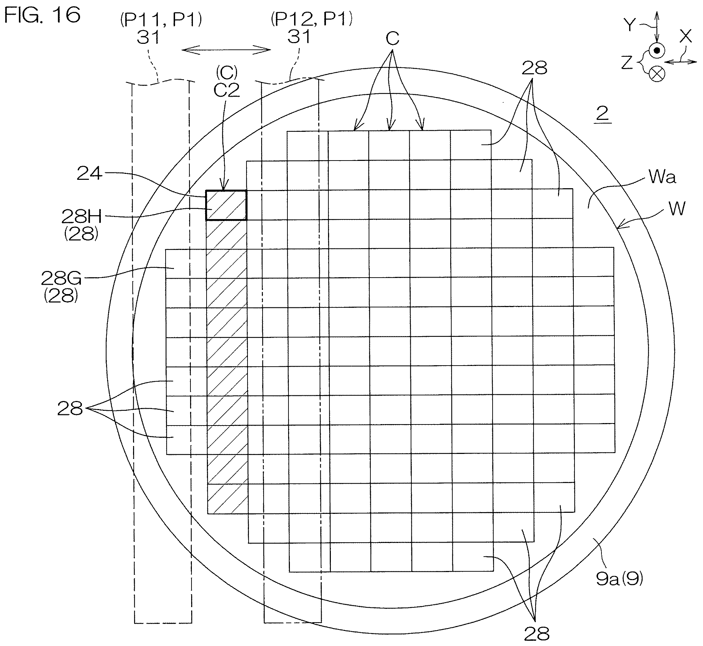

FIG. 12 is a flowchart illustrating a flow of the first inspecting step (Step S11 in FIG. 11). FIG. 13 is a schematic plan view for describing the first inspecting step (Step S11). FIGS. 14A to 15C are schematic sectional views for describing the first inspecting step (Step S11). FIGS. 14A to 15C are views as viewed from arrow XIV in FIG. 13. FIG. 16 is a schematic plan view for describing the second inspecting step (Step S12 in FIG. 11). In FIGS. 13 to 16, two positions are described in parentheses around a reference sign "31." For example, the description "(P11, P1)" provided around reference sign "31" in FIG. 13 indicates that the heat insulating member 31 is positioned at a first retracted position P11 and the first retracted position P11 is included in the inspection position P1. Also, in FIG. 13, the description "(P12, P1)" around the reference sign "31" indicates that the heat insulating member 31 is positioned at a second retracted position P12 and the second retracted position P12 is included in the inspection position P1. The same applies to FIGS. 14A to 16.

Referring to FIG. 13, the imaging region 24 has a rectangular shape. The imaging region 24 may have a shape other than the rectangular shape. The size of one imaging region 24 is sufficiently smaller than the size of the bonded substrate W. The infrared camera 10 moves to a position where the imaging region 24 on the first principal surface Wa coincides with the imaging target region 28 to be described later and images the imaging region 24. It is thereby possible to execute the defect inspection in a wide range.

A plurality of imaging target regions 28 in which the imaging region 24 can be set are formed on the first principal surface Wa of the bonded substrate W. One imaging target region 28 has the same size and the same shape as one imaging region 24. In FIG. 13, although the plurality of imaging target regions 28 do not overlap each other in plan view, the plurality of imaging target regions 28 may partially overlap each other in plan view.

In the present preferred embodiment, the plurality of imaging target regions 28 are arrayed in one imaging target column C extending in the second direction Y and aligned in the first direction X in the plurality of imaging target columns C. The number of imaging target columns C aligned in the first direction X is not less than several and less than one hundred and several tens. Preferably, the number of imaging target columns C aligned in the first direction X is not less than several tens and less than one hundred and several tens. Then, one imaging target column C includes not less than several tens and less than one hundred and several tens of the imaging target regions 28. For the sake of simplicity, FIG. 13 exemplifies a case where the number of imaging target columns C aligned in the first direction X is 11 and the number of imaging target regions 28 included in one imaging target column C is 15 at the maximum. The plurality of imaging target regions 28 are set in a region excluding the peripheral edge portion of the bonded substrate W.

On the first principal surface Wa, an imaging path 29 along the first direction X or the second direction Y is set on the plurality of imaging target regions 28. The imaging path 29 is a movement path of the imaging region 24. In the present preferred embodiment, the imaging path 29 has a meandering shape. The controller 6 controls the camera moving unit 11 and moves the imaging region 24 along the imaging path 29 on the plurality of imaging target regions 28, and controls the infrared camera 10 to image the imaging region 24 disposed in each imaging target region 28.

The imaging target region 28 in which the imaging region 24 is first disposed is defined as a first imaging target region 28A. The first imaging target region 28A is the imaging target region 28 included in a first imaging target column C1 that is an imaging target column on one extreme side (left side in FIG. 13) in the first direction X. As the infrared camera 10 moves along the second direction Y, the imaging target region 28 in which the imaging region 24 is disposed changes from the first imaging target region 28A to a second imaging target region 28B positioned on the other side (upper side in FIG. 13) in the second direction Y. Specifically, as the infrared camera 10 moves along the second direction Y, the imaging target region 28 in which the imaging region 24 is disposed changes to another imaging target region 28 adjacent in the second direction Y.

When the imaging of all of the imaging target regions 28 included in one imaging target column C is completed, the imaging target region 28 included in the next imaging target column C is imaged. The first inspecting step (Step S11) is repeated until imaging of all of the imaging target regions 28 is completed. The defect inspection is thereby executed in an entire region except for a peripheral edge portion of the first principal surface Wa.

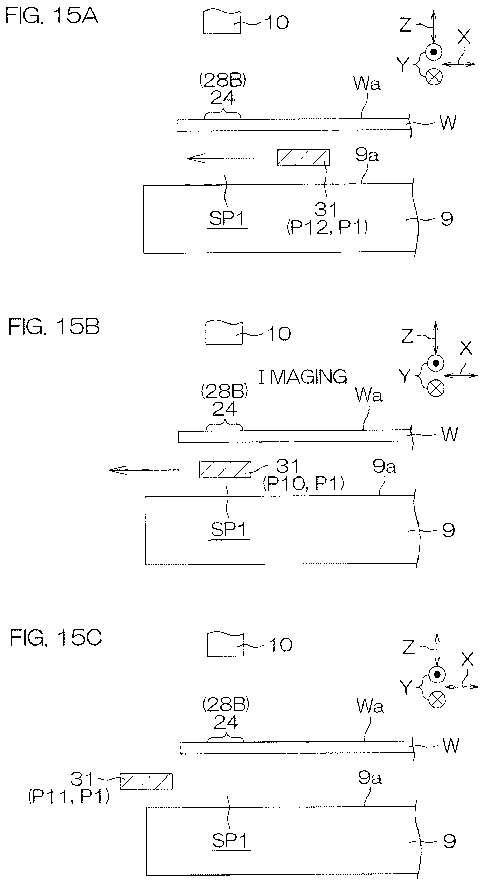

Hereinafter, the first inspecting step (Step S11) shall be described in detail with reference to FIGS. 12 and 13. FIGS. 14A to 14C and FIGS. 15A to 15C shall be referenced where appropriate. At the start of the first inspecting step (Step S11), the controller 6 controls the heat insulating member moving unit 50 and leads out the heat insulating member 31 from the heater retracted position P2 to the inspection position P1 (Step S21 in FIG. 12). Specifically, the heat insulating member 31 is disposed at the first retracted position P11.

Then, the controller 6 controls the camera moving unit 11 and changes the imaging region 24 in the bonded substrate W (Step S22 in FIG. 12). At the start of the defect inspection on the bonded substrate W, the imaging region 24 is disposed in the first imaging target region 28A included in the first imaging target column C1. In FIG. 13, the imaging target region 28 included in the first imaging target column C1 is hatched in consideration of visibility.

In the first inspecting step (Step S11), the heat insulating member 31 is reciprocated between the first retracted position P11 and the second retracted position P12 (Step S23 in FIG. 12). The first retracted position P11 is a position retracted to one side (for example, the left side in FIG. 13) in the first direction X with respect to the first space SP1 sandwiched by the imaging region 24 and the heater unit 9. The second retracted position P12 is a position retracted to the other side (for example, the right side in FIG. 13) in the first direction X with respect to the first space SP1. In other words, the first retracted position P11 and the second retracted position P12 are examples of retracted positions where the heat insulating member 31 and the imaging region 24 do not overlap each other when viewed from the normal direction Z. The first retracted position P11 and the second retracted position P12 are examples of retracted positions retracted laterally from the heat insulation position P10. The first retracted position P11 and the second retracted position P12 are included in the inspection position P1.

When imaging the imaging region 24 disposed in the first imaging target region 28A, as illustrated in FIG. 14A, the controller 6 controls the heat insulating member moving unit 50 and moves the heat insulating member 31 disposed in the first retracted position P11 along the first direction X toward the other side (the right side in FIG. 13) in the first direction X (Step S23 in FIG. 12, heat insulating member moving step).

As illustrated in FIG. 14B, thereafter, at a timing at which the heat insulating member 31 passes through the heat insulation position P10 set in the first space SP1 (the heat insulating member 31 is positioned at the heat insulation position P10), the controller 6 controls the infrared camera 10 to image the imaging region 24 (imaging step, Step S24 in FIG. 12). As illustrated in FIG. 14C, when the heat insulating member 31 moving in the first direction X reaches the second retracted position P12, the controller 6 stops the movement of the heat insulating member 31 in the first direction X.

The time required for the process for one imaging region 24 (the step of Step S22 and the process of Step S23) is, for example, about 1 second.

An interval W11 (FIG. 13) in the first direction X between the first retracted position P11 and the heat insulation position P10 is narrower than the radius of the bonded substrate W. The interval W11 is wider than the region width 24W (FIG. 13). The interval W11 may be narrower than twice the region width 24W.

An interval W12 (FIG. 13) in the first direction X between the second retracted position P12 and the heat insulation position P10 is narrower than the radius of the bonded substrate W. The interval W12 is wider than the region width 24W. The interval W12 may be narrower than twice the region width 24W.

Since the interval W11 and the interval W12 (FIG. 13) are narrow, the movement range of the heat insulating member 31 in the first direction X is also narrow. Accordingly, the time required for reciprocating movement of the heat insulating member 31 can be shortened.

After the imaging of the imaging region 24, it is checked whether or not the imaging of all of the imaging target regions 28 included in the current imaging target column C is completed (Step S25 in FIG. 12). In a case where the un-imaged imaging target region 28 is included in the first imaging target column C1 that is the current imaging target column (NO in Step S25 in FIG. 12), the steps of Steps S22 to S24 are executed.

Specifically, after the end of the first imaging target region 28A, the imaging region 24 is moved by one position toward the other side in the second direction Y (the upper side in FIG. 13) and is disposed in the second imaging target region 28B (Step S22 in FIG. 12).

When imaging the imaging region 24 disposed in the second imaging target region 28B, as illustrated in FIG. 15A, the controller 6 controls the heat insulating member moving unit 50 and moves the heat insulating member 31 disposed in the second retracted position P12 along the first direction X toward one side (left side in FIG. 13) in the first direction X (Step S23 in FIG. 12).

As illustrated in FIG. 15B, thereafter, at a timing at which the heat insulating member 31 passes through the heat insulation position P10 set in the first space SP1 (at the heat insulation position P10), the controller 6 causes the infrared camera 10 to image the imaging region 24 (Step S24 in FIG. 12). Then, as illustrated in FIG. 15C, when the heat insulating member 31 moving in the first direction X reaches the first retracted position P11, the controller 6 stops the movement of the heat insulating member 31.

Steps S22 to S24 in FIG. 12 are repeated until there is no un-imaged imaging target region 28 included in the current imaging target column C. At this time, in the step of Step S23, the movement of the heat insulating member 31 to the other side in the first direction X and the movement of the heat insulating member 31 to the one side in the first direction X are alternately executed. When the imaging of all of the imaging target regions 28 included in the current imaging target column C is completed (YES in Step S25 in FIG. 12), next, it is checked whether or not the imaging of all of the imaging target columns C is completed (Step S26 in FIG. 12). Then, in a case where an un-imaged imaging target column C remains (NO in Step S26), the imaging target column C is changed to the next imaging target column C (Step S27 in FIG. 12).

As illustrated in FIG. 16, when the imaging is completed in a state where the imaging region 24 is disposed in a seventh imaging target region 28G, it is assumed that the un-imaged imaging target region 28 does not remain in the first imaging target column C1 that is a current imaging target column C (YES in Step S25) but the un-imaged imaging target column C remains (NO in Step S26), and the imaging target column C is changed from the first imaging target column C1 to a next second imaging target column C2 (changed to the imaging target column C which is second from the left in FIG. 16). Then, since the next imaging region 24 is an eighth imaging target region 28H, the controller 6 controls the camera moving unit 11 such that the imaging region 24 is disposed in the eighth imaging target region 28H. In FIG. 16, the imaging target region 28 included in the second imaging target column C2 is hatched in consideration of visibility.

When the imaging target column C is changed, the position of the imaging region 24 in the first direction X changes. Therefore, the position in the first direction X of the heat insulation position P10 of the heat insulating member 31 is changed in accordance with the change of the imaging target column C. As illustrated in FIG. 16, the positions in the first direction X of the first retracted position P11 of the heat insulating member 31 and the second retracted position P12 of the heat insulating member 31 are also changed in accordance with the movement of the heat insulation position P10.

Then, the steps of Steps S22 to S25 and the step of Step S27 in FIG. 12 are repeated until the imaging of all of the imaging target columns C is completed, that is, until there is no un-imaged imaging target region 28 over the entire first principal surface Wa. When the imaging of all of the imaging target columns C ends (YES in Step S26 in FIG. 12), the first inspecting step (Step S11) ends.

When the first inspecting step (Step S11) ends, the controller 6 refers to the memory 6b and selects whether or not to execute the second inspecting step (Step S12) next (selecting step). As described above, in the example of FIG. 11, the memory 6b of the controller 6 stores the information indicating that both the first inspecting step (Step S11) and the second inspecting step (Step S12) are to be executed, and stores the information indicating that the first inspecting step (Step S11) and the second inspecting step (Step S12) are to be executed in this order. Therefore, the CPU 6a (FIG. 1) of the controller 6 selects the second inspecting step (Step S12) as the inspecting step to be executed next.

Upon completion of the first inspecting step (Step S11), the controller 6 then executes the second inspecting step (Step S12 in FIG. 11) while continuing heating by the heater unit 9. The second inspecting step (Step S12) is a step of inspecting the bonded substrate W by executing the second defect inspection (FIG. 7) described above. In a state where the bonded substrate W is in the thermal equilibrium state, the second inspecting step (Step S12) is started. Although heating by the heater unit 9 is continued even after the second inspecting step (Step S12) is started, since the bonded substrate W is already in the thermal equilibrium state, the temperature of the bonded substrate W no longer rises.

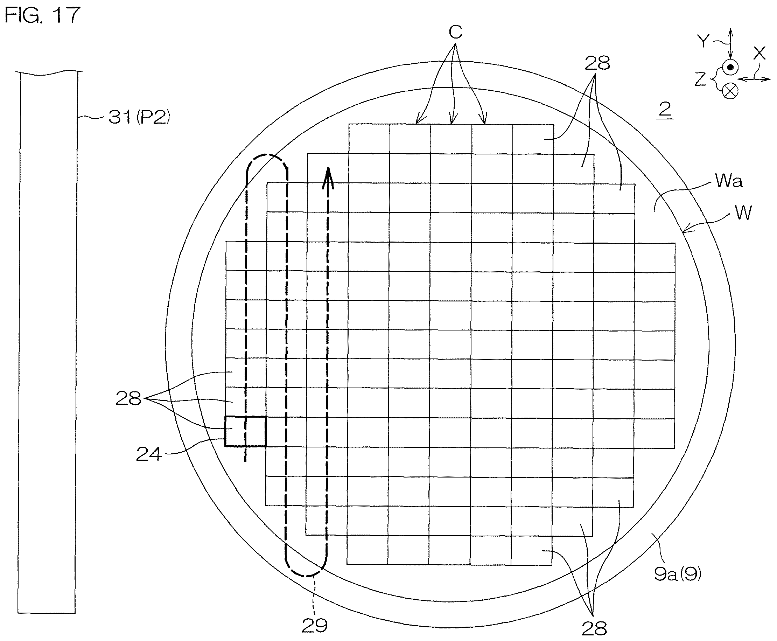

FIG. 17 is a schematic plan view for describing the second inspecting step. As illustrated in FIG. 17, in the second inspecting step (Step S12), the controller 6 controls the camera moving unit 11 and moves the imaging region 24 along the meandering imaging path 29. The controller 6 causes the infrared camera 10 to image the imaging region 24 disposed in each imaging target region 28.

The second inspecting step (Step S12) is executed in a state where the heat insulating member 31 is disposed at the heater retracted position P2. That is, in the second inspecting step (Step S12), the infrared camera 10 images the imaging region 24 in a state where the heat insulating member 31 is not positioned at the heat insulation position P10. In other aspects, the second inspecting step (Step S12) is the same as the first inspecting step (Step S11). In the state where the heat insulating member 31 is disposed at the heater retracted position P2, the heat insulating member 31 is not heated by the heater unit 9. Therefore, the temperature of the heat insulating member 31 heated by the heater unit 9 can be lowered by natural cooling.

In the second inspecting step (Step S12), the heat insulating member 31 does not reciprocate between the first retracted position P11 and the second retracted position P12. In the second inspecting step (Step S12), the time required for one imaging region 24 can be shortened as compared with the first inspecting step (Step S11).

After the end of the second inspecting step (Step S12), the inspected bonded substrate W is carried out from the defect inspecting unit 2. Then, the bonded substrate W is transferred to the carry-out unit PU2 and is carried to the outside of the defect inspection apparatus 1 via the carry-out unit PU2.

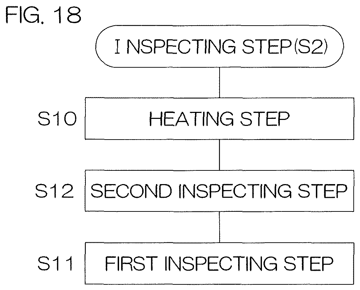

FIG. 18 is a flowchart illustrating a flow of the defect inspecting step (Step S2) according to the first modification example in which the inspection order is changed. In the defect inspecting step, the controller 6 may execute the heating step (Step S10), the second inspecting step (Step S12), and the first inspecting step (Step S11) in this order.

Also, in the defect inspecting step of FIGS. 11 and 18, only one of the first inspecting step (Step S11) and the second inspecting step (Step S12) may be executed on one bonded substrate W, and the other may be omitted. In this case, information indicating that the first inspecting step (Step S11) or the second inspecting step (Step S12) is to be executed is stored in the memory 6b of the controller 6. Therefore, the CPU 6a (FIG. 1) of the controller 6 selects the first inspecting step (Step S11) or the second inspecting step (Step S12) as the inspecting step to be executed.

For example, when the bonded substrate W is a substrate of a type in which the amount of the second infrared ray F2 emitted from the defect portion 41 is larger than the amount of the second infrared ray F2 emitted from the sound portion 42 on the first principal surface Wa (FIG. 10), the first inspecting step (Step S11) is more suitable as the defect inspecting step of FIGS. 11 and 18 than the second inspecting step (Step S12). On the other hand, when the bonded substrate W is a substrate of the other than the type described above (FIG. 9), the second inspecting step (Step S12) is more suitable as the defect inspecting step of FIGS. 11 and 18 than the first inspecting step (Step S11) from the viewpoint of shortening the inspection time.

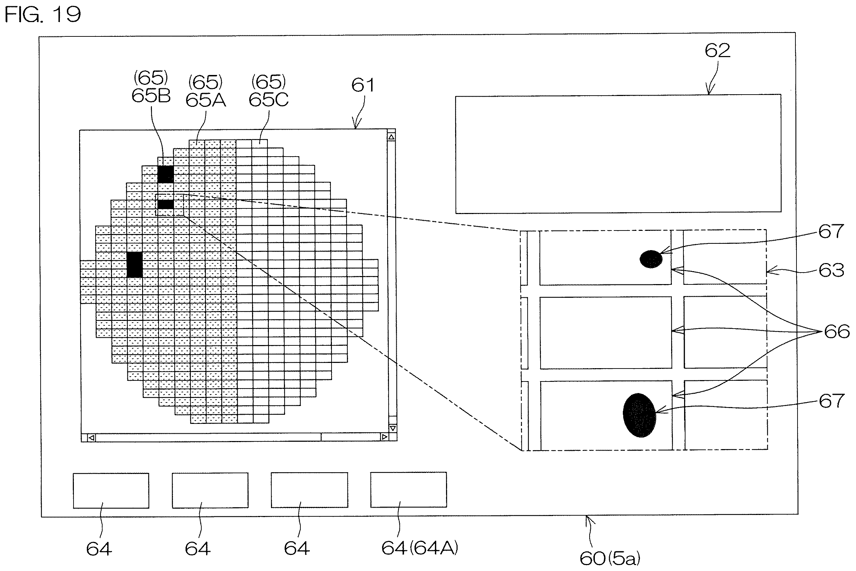

Based on the type of the bonded substrate W (the material of the bonded substrate W), the user may select which of the first inspecting step (Step S11) and the second inspecting step (Step S12) is to be executed as the defect inspecting step in FIGS. 11 and 18, by using an inspection selection button 64A (FIG. 19) described below.

In this case, the type of the inspecting step (one of the first inspecting step (Step S11) and the second inspecting step (Step S12)) selected by the inspection selection button 64A (FIG. 19) is stored in the memory 6b of the controller 6. As a matter of course, which of the first inspecting step (Step S11) and the second inspecting step (Step S12) is to be executed may be stored in the memory 6b in advance.

FIG. 19 is a diagram illustrating an inspection screen 60 displayed on the display unit 5a. The inspection screen 60 includes an inspection result display portion 61, an inspection condition input portion 62, a void display portion 63, and a plurality of operation buttons 64.

The inspection result display portion 61 indicates a progress status of the currently executed defect inspection (defect inspecting step) and a distribution of the imaging target regions 28 (FIG. 13, etc.) in which the void 40 is assumed to exist. The inspection result display portion 61 includes a plurality of imaging target images 65 respectively corresponding to the plurality of imaging target regions 28. The plurality of imaging target images 65 include a first image 65A corresponding to the imaging target region 28 in which the defect inspection has ended and the void 40 does not exist, a second image 65B corresponding to the imaging target region 28 in which the defect inspection has ended and the void 40 exists, and a third image 65C corresponding to the imaging target region 28 in which the defect inspection has not yet been executed. The first image 65A, the second image 65B, and the third image 65C are color-coded by mutually different colors.

The inspection condition input portion 62 includes an input field in which the user inputs defect inspection conditions.

The void display portion 63 displays the distribution of the voids 40 (FIG. 8, etc.) in the imaging target region 28 where the voids 40 exist. The void display portion 63 includes, for example, an enlarged image 66 of the second image 65B and a void image 67 corresponding to the void 40.

The controller 6 calculates position information (address) of the void 40 detected in the defect inspection and stores the position information. The controller 6 generates the second image 65B of the inspection result display portion 61 and the void image 67 of the void display portion 63 based on the position information.

The plurality of operation buttons 64 include at least one inspection selection button 64A for inspection selection. When the user selects the inspection selection button 64A, the defect inspecting step to be executed can be switched between the first inspecting step (Step S11) and the second inspecting step (Step S12).

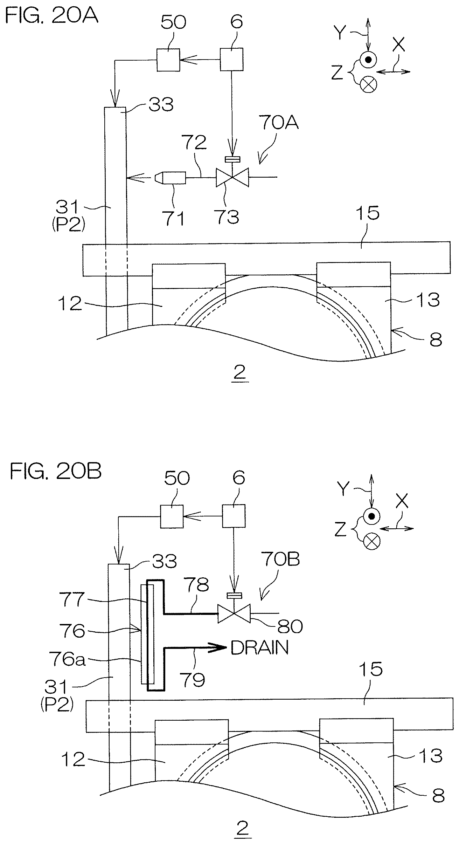

FIG. 20A is a plan view for describing a second modification example in which the defect inspecting unit 2 includes a cooling unit 70A.

The cooling unit 70A blows a cooling gas having an ordinary temperature or a temperature lower than the ordinary temperature to a region on the second end portion 33 side of the heat insulating member 31 disposed at the heater retracted position P2. The cooling unit 70A includes a cooling gas nozzle 71 that blows a cooling gas to the heat insulating member 31, a cooling gas piping 72 that supplies the cooling gas to the cooling gas nozzle 71, and an on-off valve 73 that opens and closes the cooling gas piping 72. When the cooling gas piping 72 is opened by the on-off valve 73, the cooling gas is blown from the cooling gas nozzle 71. When the cooling gas piping 72 is closed, the blowing of the cooling gas from the cooling gas nozzle 71 is stopped. The cooling gas includes, for example, an inert gas, air, etc. The cooling gas may have a temperature of, for example, not lower than 5°C and not higher than ordinary temperature. The cooling gas is preferably at a lower temperature (for example, not lower than 5°C and not higher than 15°C).

FIG. 20B is a plan view for describing a third modification example in which the defect inspecting unit 2 includes a cooling unit 70B.

The cooling unit 70B includes a cooling plate 76. The cooling plate 76 has a cooling surface 76a facing the heat insulating member 31 disposed at the heater retracted position P2. The cooling surface 76a may be constituted by a side surface of the cooling plate 76, may be constituted by an upper surface of the cooling plate 76, or may be constituted by a lower surface of the cooling plate 76.

The cooling plate 76 incorporates, for example, a cooling fluid pipe 77 constituting a cooling fluid flow passage in the cooling plate 76. A cooling fluid supply pipe 78 to supply a cooling fluid to the cooling fluid pipe 77 and a cooling fluid drain pipe 79 to drain a cooling fluid from the cooling fluid pipe 77 are connected to the cooling fluid pipe 77. The cooling fluid supply pipe 78 is provided with a cooling fluid supply valve 80 that opens and closes the cooling fluid supply pipe 78. The cooling plate 76 has, for example, a temperature of not lower than 5°C and not higher than ordinary temperature. In order to quickly cool the bonded substrate W, the cooling plate 76 is preferably at a lower temperature (for example, not lower than 5°C and not higher than 15°C). By cooling the heat insulating member 31 by the cooling plate 76, the heat insulating member 31 can be satisfactorily cooled.

According to the second modification example and the third modification example, the defect inspecting unit 2 includes the cooling units 70A and 70B. In a state where the heat insulating member 31 is disposed at the inspection position P1, the heat insulating member is heated by the heater unit 9 and stores heat. Heat dissipation of the heat insulating member 31 can be promoted by cooling the heat insulating member 31 disposed at the heater retracted position P2 by the cooling units 70A and 70B. It is thereby possible to lower the temperature of the heat insulating member 31.

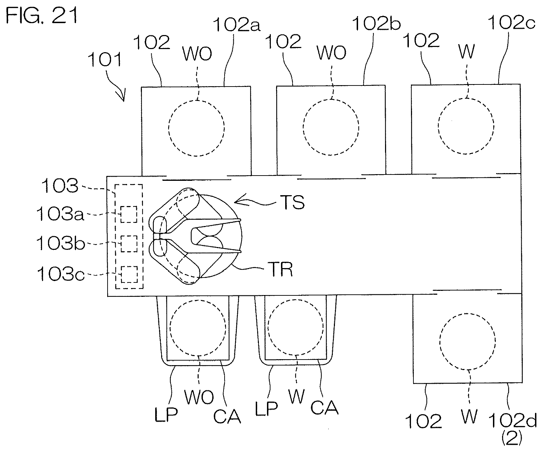

FIG. 21 is a schematic view of a substrate bonding apparatus 101 including the defect inspecting unit 2 as viewed from above. The substrate bonding apparatus 101 includes a load port LP that holds a carrier CA that houses a substrates WO such as a front-opening unified pod (FOUP), a plurality of processing units 102 that process the substrates WO transferred from the carrier CA on the load port LP, a transfer system TS that transfers the substrates WO before and after being processed by the plurality of processing units 102, and a controller 103 that controls the substrate bonding apparatus 101.

The transfer system TS carries the substrates WO out from the carrier CA on the load port LP and carries the substrates WO into the processing unit 102. The transfer system TS further carries the substrates WO out from the processing unit 102 and carries the substrates WO into the carrier CA on the load port LP. The carrier CA into which the substrates WO is carried may be the same carrier CA from which the substrates WO is carried out or may be a different carrier CA. The transfer system TS may transfer the substrates WO from one processing unit 102 to another processing unit 102. The transfer system TS may include at least one transfer robot TR that transfers one or more substrates WO in a horizontal orientation.

The processing unit 102 may be a single substrate processing type processing unit 102 that processes the substrates WO one by one, or may be a batch processing unit 102 that collectively processes a plurality of substrates WO. FIG. 21 shows an example in which the plurality of processing units 102 include an activating unit 102a, a cleaning unit 102b, a bonding unit 102c, and a defect inspecting unit 102d. The defect inspecting unit 102d is the defect inspecting unit 2 illustrated in FIG. 1. The defect inspecting unit 102d may be referred to as a "defect inspection apparatus." The activating unit 102a, the cleaning unit 102b, the bonding unit 102c, and the defect inspecting unit 102d are all single substrate processing type processing units 102.

The activating unit 102a is a unit that activates the bonding surface of the substrates WO by irradiating the bonding surface of the substrates WO with plasma. The cleaning unit 102b is a unit that cleans the bonded surface of the substrates WO by supplying a cleaning liquid such as pure water (deionized water: DIW) to the bonded surface of the substrates WO carried out from the activating unit 102a. The bonding unit 102c is a unit (apparatus) that bonds the two substrates WO by bringing the bonding surfaces of the two substrates WO carried out from the cleaning unit 102b into contact with each other (bonding apparatus). Unless otherwise specified, the bonding unit 102c described in the present Description bonds the substrates WO under atmospheric pressure.

The controller 103 controls electric equipment and electronic equipment provided in the substrate bonding apparatus 101. The controller 103 includes a CPU 103a that executes processing of information such as execution of a program, and a memory 103b that stores information such as a program to be executed by the CPU 103a. The controller 103 further includes a communication module 103c that executes at least one of transmission of information transmitted from the CPU 103a or the memory 103b to a device other than the controller 103 and reception of information transmitted from a device other than the controller 103 and transmitted to the CPU 103a or the memory 103b. The controller 103 controls the substrate bonding apparatus 101 to execute transferring, processing, etc., of the substrates WO described below. In other words, the controller 103 is programmed to execute transferring, processing, etc., of the substrates WO described below.

Hereinafter, the two substrates WO to be bonded are referred to as a first substrate WO and a second substrate WO. When the first substrate WO and the second substrate WO are bonded and the bonded substrate W, which is the bonded first substrate WO and second substrate WO, is inspected, the transfer system TS transfers the first substrate WO from the carrier CA on the load port LP to the activating unit 102a, and the activating unit 102a activates the front surface of the first substrate WO. Thereafter, the transfer system TS transfers the first substrate WO from the activating unit 102a to the cleaning unit 102b, and the cleaning unit 102b cleans and dries the front surface of the first substrate WO. Thereafter, the transfer system TS transfers the first substrate WO from the cleaning unit 102b to the bonding unit 102c.

As with the first substrate WO, the second substrate WO in the carrier CA on the load port LP is transferred to the activating unit 102a and the cleaning unit 102b and processed by the activating unit 102a and the cleaning unit 102b. Thereafter, the second substrate WO is transferred to the bonding unit 102c by the transfer system TS. The bonding unit 102c bonds the first substrate WO and the second substrate WO by bringing the cleaned bonding surfaces of the first substrate WO and the second substrate WO into contact with each other. Thereafter, the transfer system TS transfers the bonded substrate W, which is the bonded first substrate WO and second substrate WO, to the defect inspecting unit 102d, and the defect inspecting unit 102d inspects the bonded substrate W. The inspection of the bonded substrate W by the defect inspecting unit 102d is as described above.

The substrate bonding apparatus 101 executes the above steps from the activating step to the defect inspecting step until there is no substrates WO to be bonded from the carrier CA on the load port LP. The substrate bonding apparatus 101 further starts processing of the first substrate WO and the second substrate WO of the second set before the inspection of the first bonded substrate W (the first substrate WO and the second substrate WO of the first set) is completed. The same applies to the third and subsequent sets of the first substrate WO and the second substrate WO. Therefore, the activating unit 102a processes the subsequent substrates WO even while another processing unit 102 such as the cleaning unit 102b processes the substrates WO. The same applies to the cleaning unit 102b, the bonding unit 102c, and the defect inspecting unit 102d.

Next, the effects of the present preferred embodiment shall be described.

In the present preferred embodiment, the infrared camera 10 images the imaging region 24 set on the bonded substrate W in the state where the heat insulating member 31 is positioned at the heat insulation position P10. In the state where the heat insulating member 31 is positioned at the heat insulation position P10, second infrared ray F2 is blocked by heat insulating member 31. Therefore, the infrared camera 10 detects the first infrared ray F1 emitted from the imaging region 24, and does not detect the second infrared ray F2 transmitted through the imaging region 24 of the bonded substrate W. Therefore, the imaged image can be generated based only on the first infrared ray F1. It is thereby possible to accurately determine whether or not there is the void 40 (defect) in the imaging region 24. Therefore, it is possible to accurately inspect whether or not there is the void 40 (defect) in the interior of the bonded substrate W regardless of the type of the bonded substrate W (material of the bonded substrate W).

In the present preferred embodiment, one defect inspecting unit 2 can execute two types of defect inspection including the first defect inspection and the second defect inspection. The first defect inspection is a defect inspection in which the first infrared ray F1 is detected by the infrared camera 10 and the second infrared ray F2 is not detected. The second defect inspection is a defect inspection in which both the first infrared ray F1 emitted from the imaging region 24 and the second infrared ray F2 transmitted through the imaging region 24 of the bonded substrate W are detected by the infrared camera 10.

Depending on the type of the bonded substrate W to be inspected (the material of the bonded substrate W), the user can select whether to execute either or both of the first defect inspection and the second defect inspection by the defect inspecting unit 2. By executing the defect inspection in accordance with the type of the bonded substrate W (the material of the bonded substrate W), it is possible to more favorably inspect whether or not there is the void 40 (defect) in the interior of the bonded substrate W.

Also, in the present preferred embodiment, the heat insulating member 31 is positioned at the heat insulation position P10 during the first defect inspection (first inspecting step (Step S11)). On the other hand, the heat insulating member 31 is disposed at the heater retracted position P2 during the second defect inspection (second inspecting step (Step S12)). The controller 6 controls the heat insulating member moving unit 50 and moves the heat insulating member 31 in the first direction X between the heater retracted position P2 and the inspection position P1, the inspecting step executed on the bonded substrate W is thereby switched between the first inspecting step (Step S11) and the second inspecting step (Step S12). Therefore, the type of the inspecting step executed on the bonded substrate W can be smoothly switched between the first inspecting step (Step S11) and the second inspecting step (Step S12) .

Also, in the present preferred embodiment, since the heat insulating member 31 has the length L1 that can overlap the entire region of the bonded substrate W in the second direction Y, the heat insulating member 31 can be disposed at the heat insulation position P10 corresponding to the imaging region 24 regardless of at which position on the first principal surface Wa of the bonded substrate W the imaging region 24 is set. Therefore, in the first defect inspection, the entire region of the bonded substrate W can be included in the inspection object.

Incidentally, if the first end portion 32 of the heat insulating member 31 is retracted further to the other side in the first direction X than the one end portion 24a of the imaging region 24, or if the second end portion 33 of the heat insulating member 31 is retracted further to the one side in the first direction X than the other end portion 24b of the imaging region 24, there is a possibility that infrared rays emitted from the heater unit 9 enter a portion of the imaging region 24 in the state where the heat insulating member 31 is positioned at the heat insulation position P10. In this case, since a portion of the imaging region 24 locally rises in temperature (occurrence of heat flowing-around), there is a possibility that it is not possible to satisfactorily determine whether or not there is the void 40 (defect) in the imaging region 24 based on the imaged image of the imaging region 24.

In the present preferred embodiment, in the state where the heat insulating member 31 is positioned at the heat insulation position P10, the third end portion 36 of the heat insulating member 31 protrudes to one side in the first direction X from the one end portion 24a of the imaging region 24. Also, in this state, the fourth end portion 37 of the heat insulating member 31 protrudes to the other side in the first direction X from the other end portion 24b of the imaging region 24. Therefore, it is possible to prevent infrared rays emitted from the heater unit 9 from entering the imaging region 24 in the state where the heat insulating member 31 is positioned at the heat insulation position P10. That is, the influence of heat flowing-around can be avoided. Since the incidence of infrared rays on the imaging region 24 can be prevented, it is possible to satisfactorily determine whether or not there is the void 40 (defect) in the imaging region 24 based on the imaged image of the imaging region 24.

Also, in the present preferred embodiment, the first inspecting step (Step S11) and the second inspecting step (Step S12) are started after the entire region of the bonded substrate W is in the thermal equilibrium state. That is, the defect inspection is started after the imaging region 24 of the bonded substrate W is in the thermal equilibrium state. After the bonded substrate W is in the thermal equilibrium state, the temperature of the bonded substrate W does not rise by subsequent heating by the heater unit 9. Therefore, the temperature of the bonded substrate W can be kept constant during an entire period of the first inspecting step (Step S11) and the second inspecting step (Step S12). In this case, regardless of which imaging target region 28 is imaged, the amount of infrared rays (first infrared ray F1 (FIGS. 8 to 10)) emitted from the bonded substrate W is constant. Therefore, whether or not there is the void 40 (defect) can be detected with high accuracy in a substantially entire region of the bonded substrate W.

Incidentally, a case where the infrared camera 10 images a plurality of imaging target regions 28 included in one imaging target column C while keeping the heat insulating member 31 disposed at the heat insulation position P10 shall be considered. In this case, by keeping the heat insulating member 31 disposed at the heat insulation position P10, there is a possibility that the plurality of imaging target regions 28 included in the imaging target column C are cooled in accordance with the progress of the inspecting step and the temperature of the plurality of imaging target regions 28 lowers. Therefore, for example, there is a possibility that the temperature of the imaging target region 28 differs between a case where the first imaging target region 28A (FIG. 13) is imaged by the infrared camera 10 and a case where the seventh imaging target region 28G (FIG. 16) is imaged by the infrared camera 10. In this case, there is a possibility that the void 40 (defect) included in the imaging target region 28 cannot be detected.

On the other hand, in the present preferred embodiment, the infrared camera 10 images the imaging region 24 at a timing at which the moving heat insulating member 31 passes (is positioned at) the heat insulation position P10. In this case, the heat insulating member 31 can be disposed at a position other than the heat insulation position P10 except for the timing at which the imaging region 24 is imaged by the infrared camera 10. Therefore, it is possible to prevent or suppress the temperature of the plurality of imaging target regions 28 included in the imaging target column C from lowering in accordance with the progress of the inspecting step. It is thereby possible to accurately detect the void 40 (defect) included in each imaging target region 28.

Also, in the present preferred embodiment, the imaging region 24 is moved in the second direction Y by the camera moving unit 11. The imaging region 24 moves in the second direction Y orthogonal to the first direction X, which is the moving direction of the heat insulating member 31. In other words, the imaging region 24 moves in the second direction Y in which the heat insulating member 31 extends. Therefore, even when the imaging region 24 moves in the second direction Y, it is not necessary to move the heat insulating member 31. Accordingly, the heat insulating member moving unit 50 which moves the heat insulating member 31 can be simplified.

The defect inspecting unit 102d (defect inspecting unit 2) ends the inspection on at least one bonded substrate W before the bonding unit 102c starts to bond the final set of two substrates WO among the plurality of sets of two substrates WO. Therefore, in a case where a defect such as the void 40 is present in the bonded substrate W, this can be identified before the bonding unit 102c starts to bond the final set of two substrates WO. Furthermore, since the bonding unit 102c and the defect inspecting unit 102d (defect inspecting unit 2) are provided in the substrate bonding apparatus 101, the time from when the two substrates WO are bonded to when the substrates WO are inspected can be shortened as compared with a case where these are separate devices.

For example, in the case where the bonding unit 102c and the defect inspecting unit 102d (defect inspecting unit 2) are separate devices, it is necessary to transfer the bonded substrate W from the bonding unit 102c to the load port LP for the bonding unit 102c and carry the bonded substrate W into the carrier CA on the same load port LP. Further, it is necessary to transfer the carrier CA onto the load port LP for the defect inspecting unit 102d and to transfer the bonded substrate W in the same carrier CA from the same load port LP to the defect inspecting unit 102d (defect inspecting unit 2). Therefore, by providing the bonding unit 102c and the defect inspecting unit 102d (defect inspecting unit 2) in the substrate bonding apparatus 101, time from when the two substrates WO are bonded to when the substrates WO are inspected can be shortened.

In a case where there is a defect in the bonded substrate W other than the last bonded substrate W, it is possible to prevent the occurrence of the defective bonded substrate W by stopping the bonding in the bonding unit 102c. The number of defective bonded substrates W can be reduced by changing bonding conditions or conditions of the step executed before bonding. It is thereby possible to increase the yield of the bonded substrate W. In particular, since the time from when the two substrates WO are bonded to when the substrates WO are inspected can be shortened, it is possible to quickly take measures such as stopping as compared with the case where the bonding unit 102c and the defect inspecting unit 102d (defect inspecting unit 2) are separate devices.

Although a preferred embodiment and modification examples of the present invention have been described above, the present invention may be implemented in yet other modes.

For example, the moving heat insulating member 31 may be temporarily stopped at the heat insulation position P10 (FIG. 14B), and in this state, the infrared camera 10 may image the imaging region 24.

Also, although a case where the infrared camera 10 is moved in the horizontal direction by the camera moving unit 11 in order to move the imaging region 24 on the bonded substrate W was described as an example in the above-described preferred embodiment, the imaging region 24 may be moved by moving both the bonded substrate W and the heater unit 9 in the horizontal direction while keeping the infrared camera 10 still. In this case, the defect inspecting unit 2 needs to include, as the imaging region moving unit, a first moving unit for moving the substrate holding unit 8 in the horizontal direction and a second moving unit for moving the heater unit 9 in the horizontal direction. The first moving unit and the second moving unit may be actuators.

Also, the first moving unit for moving the substrate holding unit 8 in the horizontal direction may be provided, and only the bonded substrate W may be moved in the horizontal direction in a state where the infrared camera 10 and the heater unit 9 are kept still. In this case, a width of the heater unit 9 in the first direction X and the second direction Y needs to be twice or more the diameter of the bonded substrate W. This eliminates the need for various safety measures by moving the heater unit 9 which is a heat source.

Also, although a case where the heater unit 9 is disposed below the bonded substrate W and the bonded substrate W is imaged by the infrared camera 10 from above the bonded substrate W was described as an example, the heater unit 9 may be disposed above the bonded substrate W and the bonded substrate W may be imaged by the infrared camera 10 from below the bonded substrate W.

Also, a heating unit 90 (illustrated by an alternate long and two short dashed line in FIG. 1) for heating the bonded substrate W housed in the carry-in unit PU1 may be provided in the carry-in unit PU1. The heating unit 90 may be a resistance heating type heater unit the same as the heater unit 9. The heating unit 90 may have an arrangement provide with an infrared lamp.

It is noted that, although expressions such as "along," "horizontal," and "vertical" are used for the preferred embodiments described above, it is not required that "along" "horizontal" and "vertical" apply strictly. That is, the respective expressions allow deviations in manufacturing precision, installation precision, etc.

Also, although there are cases where respective arrangements are represented schematically as blocks, the shapes, sizes, and positional relationships of the respective blocks do not represent the shapes, sizes, and positional relationships of the respective arrangements.

Various modifications besides the above may be made within the scope stated in the claims.

While a preferred embodiment of the present invention has been described in detail above, this is merely a specific example used to clarify the technical contents of the present invention and the present invention should not be interpreted as being limited to these specific examples and the scope of the present invention is limited only by the appended claims.

## Claims

1. A defect inspection apparatus (1) comprising:
a substrate holding unit (8) to hold a substrate (W) having a first principal surface (Wa);
a heater unit (9) to emit infrared rays (F2) to the substrate (W) held by the substrate holding unit (8) and heat the substrate (W) in a non-contact manner;
an infrared camera (10) to face the first principal surface (Wa) of the substrate (W) held by the substrate holding unit (8) and image an imaging region (24) on the first principal surface (Wa);
a heat insulating member (31) to absorb infrared rays (F2) emitted by the heater unit (9); and
a heat insulating member moving unit (50) to move the heat insulating member (31) between a heat insulation position (P10) where the heat insulating member (31) and the imaging region (24) overlap each other when viewed from a normal direction (Z) of the first principal surface (Wa) and a retracted position (P2) where the heat insulating member (31) and the imaging region (24) do not overlap each other when viewed from the normal direction (Z),
wherein the substrate holding unit (8) is positioned between the heater unit (9) and the infrared camera (10) in the normal direction (Z).

2. The defect inspection apparatus (1) according to claim 1,
wherein the heat insulating member moving unit (50) moves the heat insulating member (31) in a first direction (X) along the first principal surface (Wa) of the substrate (W), and
wherein the heat insulating member (31) has a band shape extending along a second direction (Y) orthogonal to the first direction (X) and along the first principal surface (Wa) of the substrate (W).

3. The defect inspection apparatus (1) according to claim 2, wherein the heat insulating member (31) has a length that is capable of overlapping an entire region of the substrate (W) in the second direction (Y).

4. The defect inspection apparatus (1) according to claim 2 or 3, wherein a first width (W1) of the heat insulating member (31) in the first direction (X) is wider than a region width (24W) of the imaging region (24) in the first direction (X).

5. The defect inspection apparatus (1) according to any one of claims 2 to 4, further comprising: an imaging region moving unit (11) to move the imaging region (24) in the second direction (Y) in the first principal surface (Wa) of the substrate (W).

6. The defect inspection apparatus (1) according to any one of claims 1 to 5, wherein the heater unit (9) has a heating surface (9a) to face an entire region of a second principal surface (Wb) of the substrate (W) opposite to the first principal surface (Wa).

7. The defect inspection apparatus (1) according to any one of claims 1 to 6, wherein the heater unit (9) is a resistance heating type heater unit (9).

8. The defect inspection apparatus (1) according to any one of claims 2 to 4,
wherein the retracted position (P2) includes a first retracted position (P2) retracted to one side in the first direction (X) with respect to the heat insulation position (P10) and a second retracted position (P2) retracted to the other side in the first direction (X) with respect to the heat insulation position (P10),
wherein the heat insulating member moving unit (50) moves the heat insulating member (31) between the first retracted position (P2) and the second retracted position (P2) in the first direction (X), and
wherein the infrared camera (10) images the imaging region (24) at a timing at which the heat insulating member (31) moving between the first retracted position (P2) and the second retracted position (P2) is positioned at the heat insulation position (P10).

9. The defect inspection apparatus (1) according to any one of claims 1 to 8, wherein when the heat insulating member (31) is at the retracted position (P2), the heat insulating member (31) is positioned between the substrate (W) and the heater unit (9) in the normal direction (Z).

10. The defect inspection apparatus (1) according to any one of claims 1 to 9, wherein the substrate (W) includes a bonded substrate (W) having a bonding interface (Wd).

11. A substrate bonding apparatus (101) comprising:
a bonding unit (102c) which bonds two substrates (W); and
the defect inspection apparatus (1) according to claim 10 that inspects the bonded substrate (W) that is formed by bonding the two substrates (W0) with the bonding unit (102c).

12. A defect inspection method comprising:
a substrate holding step of holding a substrate (W) having a first principal surface;
a heating step (S10) of emitting infrared rays (F2) from a heater unit (9) and heating the substrate (W) in a non-contact manner;
a heat insulating member moving step (S23) of moving a heat insulating member (31) capable of absorbing the infrared rays (F2) between a heat insulation position (P10) and a retracted position (P2);
a defect inspecting step (S2) of executing at least one of a first defect inspection of imaging an imaging region (24) on a first principal surface (Wa) by an infrared camera (10) in a state where the heat insulating member (31) is at the heat insulation position (P10) and a second defect inspection of imaging the imaging region (24) on the first principal surface (Wa) by the infrared camera (10) in a state where the heat insulating member (31) is at the retracted position (P2); and
a selecting step of selecting whether or not to execute each of the first defect inspection and the second defect inspection in the defect inspecting step (S2),
wherein the heat insulation position (P10) is a position where the heat insulating member (31) and the imaging region (24) overlap each other when viewed from a normal direction (Z) of the first principal surface (Wa), and the retracted position (P2) is a position where the heat insulating member (31) and the imaging region (24) do not overlap each other when viewed from the normal direction (Z) .
